# EUROPÄISCHE PATENTSCHRIFT

(11) **EP 0 699 914 B1**
(45) Veröffentlichungstag und Bekanntmachung des Hinweises auf die Patenterteilung: **05.01.2005**
(21) Anmeldenummer: 95107239.6
(22) Anmeldetag: 12.05.1995
(51) Int. Cl.: G01R 21/133, G01R 35/04

(54) **Anordnung zum Messen elektrischer Energie**
Electricity meter
Compteur d'énergie électrique

(30) Priorität: 05.09.1994 CH 269894
(43) Veröffentlichungstag der Anmeldung: 06.03.1996
(73) Patentinhaber: Landis+Gyr AG, 6301 Zug (CH)
(72) Erfinder: De Vries, Jacob Henk, CH-6319 Allenwinden (CH); Petr, Jan, CH-6317 Oberwil (CH); Cermeno, Raul, CH-6331 Hünenberg (CH); Hodel, Peter, CH-6300 Zug (CH)
(74) Vertreter: Rentsch, Rudolf A.

(56) Entgegenhaltungen:
- EP-A- 0 109 644
- EP-A- 0 607 711
- CH-A- 683 579
- US-A- 4 504 787
- US-A- 4 951 052
- US-A- 5 179 380
- US-A- 5 325 048

## Beschreibung

Die Erfindung bezieht sich auf eine Anordnung zum Messen elektrischer Energie gemäss dem Oberbegriff des Anspruchs 1.

Die erfindungsgemässe Anordnung wird vorzugsweise in Ein- oder Mehrphasen-Elektrizitätszählern verwendet zur Messung einer okjhder mehrerer Energiearten, wie z.B. Wirkenergie und/oder Blindenergie und/oder Scheinenergie, wobei die Energiearten jeweils ein positives und/oder negatives Vorzeichen besitzen können. Die erfindungsgemässe Anordnung ist mit mindestens einem Messystem versehen, nämlich ein Messystem pro Phase bzw. zwei Messysteme in einer 3-Leiter-Anordnung einer Dreiphasen-Anordnung und/oder ein Messystem pro gemessene Energieart.

Eine Anordnung der eingangs genannten Art ist aus der US-PS 4 504 787 bekannt, in der ein Wattstundenmeter beschrieben ist, der eine magnetoresitive Brücke enthält zur Multiplikation eines Stromes mit einer Spannung zwecks Bildung eines Ausgangssignals, welches proportional der zugehörigen Momentanleistung ist und über einen Analog/Digital-Wandler einem Mikrocomputer zugeführt wird zur Ermittlung eines Energieverbrauchs. Ein Kalibrations-Verfahren ist aus der EP 0 569 740 A1 bekannt.

In der US-PS 4 951 052 wird ein Verfahren offenbart, mit dem eine überabgetastete Analog/Digtal-Wandlung eines Eingangssignals derart verbessert wird, dass es im wesentlichen frei ist von systematischen Fehlern. Dabei finden Sigmal-Delta-Modulatoren Anwendung, die beispielsweise mit dem hier gezeigten Verfahren bei elektronischen Zählern die erforderliche Genauigkeit erreichen.

Des Weiteren offenbart die US-PS 5 179 380 einen Ein-Bit Sigma-Delta-Modulator mit verbesserter Signalstabilität.

Der Erfindung liegt die Aufgabe zugrunde, eine Anordnung zum Messen elektrischer Energie kostengünstig zu verwirklichen, deren Messysteme digital abgeglichen werden können sowie deren für eine Kalibrierung und/oder einen Kontrolltest benötigte Messzeit erheblich, ca 60 mal, reduziert werden kann, was beides auch zu grossen Kosteneinsparungen bei Test und Abgleich führt. Die Erfindung ermöglicht somit unter anderem ein digitales und schnelles Kalibrieren von Energie-Messanordnungen.

Die genannte Aufgabe wird erfindungsgemäss durch die im Kennzeichen des Anspruchs 1 angegebenen Merkmale gelöst. Vorteilhafte Ausgestaltungen der Erfindung ergeben sich aus den abhängigen Ansprüchen.

Ausführungsbeispiele der Erfindung sind in der Zeichnung dargestellt und werden im folgenden näher beschrieben.

Es zeigen:
- Fig. 1: ein prinzipielles Blockschaltbild einer grösstenteils bekannten Anordnung zur Ermittlung analoger elektrischer Leistungswerte,
- Fig. 2: ein prinzipielles Blockschaltbild einer ersten Variante einer ein einziges Messystem aufweisenden erfindungsgemässen Anordnung,
- Fig. 3: ein prinzipielles Blockschaltbild der ersten Variante einer mehrere Messysteme aufweisenden erfindungsgemässen Anordnung,
- Fig. 4: ein prinzipielles Blockschaltbild einer zweiten Variante einer ein einziges Messystem aufweisenden erfindungsgemässen Anordnung,
- Fig. 5: ein prinzipielles Blockschaltbild einer abgewandelten zweiten Variante einer mehrere Messysteme aufweisenden erfindungsgemässen Anordnung,
- Fig. 6: ein Blockschaltbild eines digitalen Hardware- Quantisierers,
- Fig. 7: eine Dämpfungskennlinie eines Digitalfilters,
- Fig. 8: ein Blockschaltbild zweier in Reihe geschalteter digitaler Integratoren und eines nachgeschalteten Dezimationsgliedes,
- Fig. 9: ein Blockschaltbild des Digitalfilters,
- Fig. 10: eine ausführliche Darstellung der zweiten Variante und
- Fig. 11: ein weitere, Ergänzungen enthaltende ausführliche Darstellung der zweiten Variante.

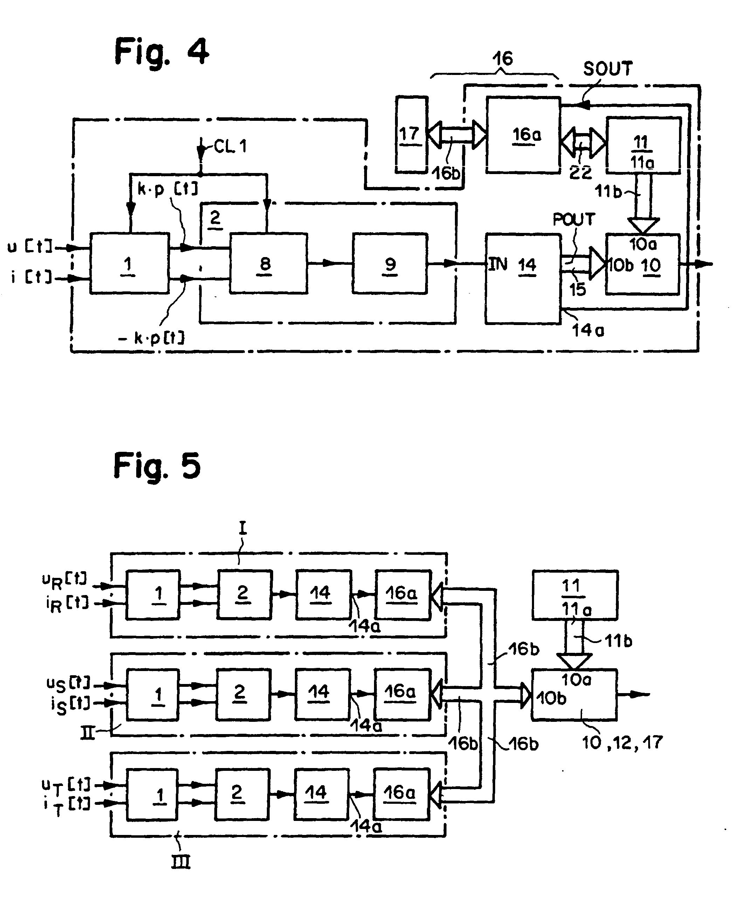

Die erfindungsgemässe Anordnung zum Messen elektrischer Energie ist in allen Varianten mit mindestens einem Messystem versehen und weist pro Messystem eine Anordnung 1 zur Ermittlung analoger Leistungswerte p[t] und einen der Anordnung 1 nachgeschalteten Analog/Digital-Wandler 2 auf (siehe Fig. 2 bis Fig. 5).

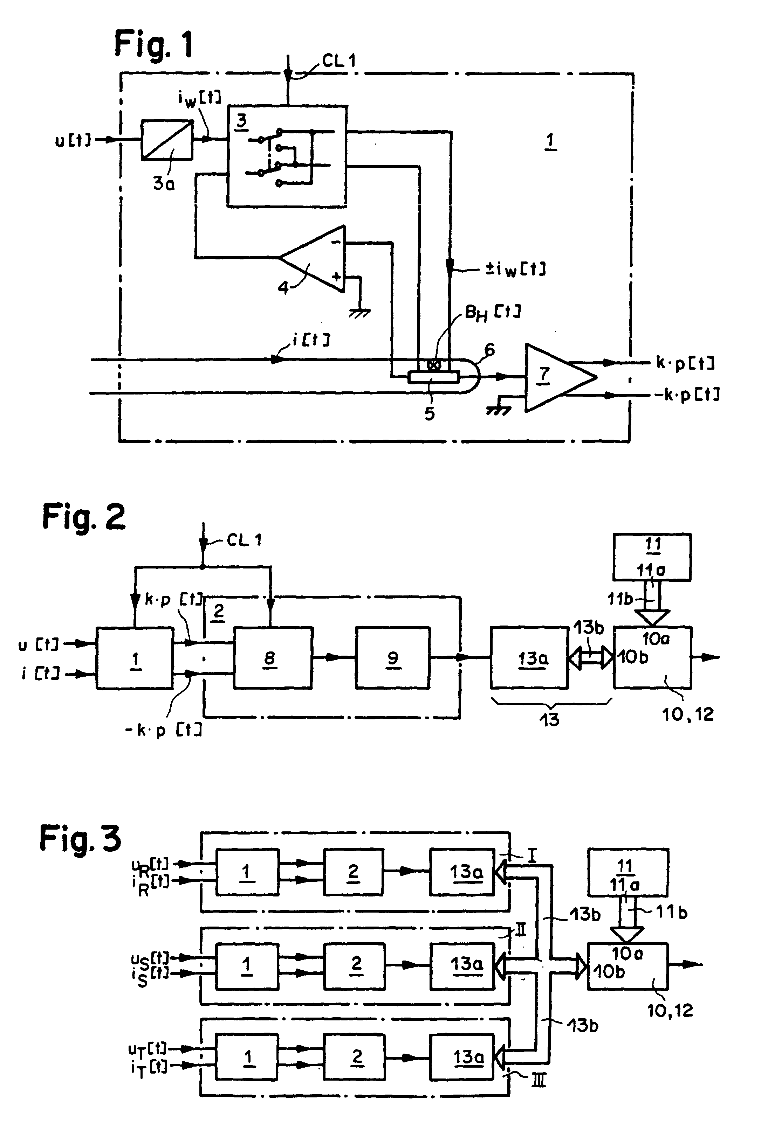

Die Anordnung 1 besitzt z. B. den in der Fig. 1 dargestellten und grösstenteils bekannten Aufbau. Sie enthält in diesem Fall einen Spannungs/Strom-Wandler 3a, einen Polwender 3, einen Regelverstärker 4, einen Magnetfeldsensor 5, der zwischen einem Hin- und Rückleiter einer U-förmigen Stromschleife 6 angeordnet ist, und einen Verstärker 7. Ein Wechselstrom i[t] fliesst im Betrieb durch die Stromschleife 6 und erzeugt eine magnetische Induktion B_{H}[t], welche vorzugsweise parallel zur Oberfläche des Magnetfeldsensors 5 wirksam ist. Der letztere ist in vorteilhafter Weise ein Hallelement. Eine zum Wechselstrom i[t] gehörige und auf ein Bezugspotential Masse bezogene einpolige Wechselspannung u[t] ist auf einen Eingang des Spannungs/Strom-Wandlers 3a geführt, dessen Ausgang mit einem ersten Anschluss eines zweipoligen Eingangs des Polwenders 3 verbunden ist. Die Anordnung 1 besitzt somit als Eingangssignale den Wechselstrom i[t] und die zugehörige Wechselspannung u[t]. Der Spannungs/Strom-Wandler 3a wandelt die Spannung u[t] um in einen proportionalen Speisestrom i_{W}[t] und ist vorzugsweise ein serieller Widerstand. Der zweipolige Ausgang des Polwenders 3 ist mit einem zweipoligen Speiseeingang des Magnetfeldsensors 5 verbunden. Der Magnetfeldsensor 5 wird im Betrieb somit mit einem Magnetfeldsensorstrom i_{H}[t] gespeist, dessen Absolutwert gleich dem Speisestrom i_{W}[t] und somit proportional der Wechselspannung u[t] ist und dessen Polarität im Takt eines niederfrequenten Taktsignals CL1 mittels des Polwenders 3 periodisch umgeschaltet wird. Es gilt somit i_{H}[t] = ±i_{W}[t]. Der Polwender 3 besteht z. B. aus einem zweipoligen Umschalter, der als Polwender ausgeführt ist und dessen Steuereingang einen Takteingang der Anordnung 1 bildet, der mit dem Taktsignal CL1 gespeist ist, dessen Frequenz z. B. 2⁵ Hz beträgt. Der zweipoligen Umschalter ist vorzugsweise in CMOS-Technolgie hergestellt und besteht z. B. aus vier als "transmission gates" bezeichneten Ein/Aus-Schaltern, die mittels zweier Inverter zwei zu zwei in Gegentakt betrieben werden und so zwei einpolige Umschalter bilden, die synchron umgeschaltet werden. Die periodische Umschaltung des Speisestroms i_{W}[t] dient der Elimination der Offset-Spannung der Anordnung 1, wie noch später erläutert werden wird. Ein erster Anschluss eines zweipoligen Ausgangs des Magnetfeldsensors 5 ist z. B. auf einen ersten Eingang des Verstärkers 7 geführt, der einen zweipoligen Gegentakt-Ausgang besitzt, welcher gleichzeitig ein Ausgang der Anordnung 1 ist. Ein zweiter Eingang des Verstärkers 7 liegt z. B. an Masse. Die Spannung eines zweiten Anschlusses des zweipoligen Ausgangs des Magnetfeldsensors 5 wird mittels des Regelverstärkers 4 auf Null geregelt, so dass dieser zweite Anschluss im Betrieb virtuell an Masse liegt. Zu diesem Zweck ist der zweite Anschluss des zweipoligen Ausgangs des Magnctfeldsensors 5 mit einem invertierenden Eingang des Regelverstärkers 4 verbunden, dessen nichtinvertierender Eingang an Masse liegt und dessen Ausgang mit einem zweiten Anschluss des zweipoligen Eingangs des Polwenders 3 verbunden ist. Der Magnetfeldsensor 5 bildet das Produkt der magnetischen Induktion B_{H}[t] und des Speisestromes i_{W}[t] und damit das Produkt des Wechselstromes i[t] und der zugehörigen Wechselspannung u[t], so dass sein Ausgangssignal proportional den Leistungswerten p[t] = u[t].i[t] ist. Die beiden Ausgangssignale des Verstärkers 7 und damit der Anordnung 1 sind dann ebenfalls leistungsproportional und gleich +k.p[t] bzw. -k.p[t], wenn k eine Proportionalitätskonstante darstellt.

Der Analog/Digital-Wandler 2 enthält jeweils einen Sigma-Delta-Modulator 8 sowie ein dem letzteren nachgeschaltetes Digitalfilter 9 (siehe Fig. 2 und Fig. 4). Der zweipolige Ausgang der Anordnung 1 ist mit einem zweipoligen Eingang des Sigma-Delta-Modulators 8 verbunden, der einen Umschalteingang aufweist, der mit dem gleichen Taktsignal CL1 gespeist ist wie der Takteingang der Anordnung 1. Im Sigma-Delta-Modulator 8 ist ein nicht dargestellter Polwender vorhanden, der mittels des Taktsignals CL1 synchron mit dem Polwender 3 der Anordnung 1 periodisch umgeschaltet wird zwecks Realisierung von Polaritätsumschaltungen. Dies hat zur Folge, dass das Nutzsignal zweimal synchron umgepolt wird, einmal in der Anordnung 1 und einmal im Sigma-Delta-Modulator 8, so dass im Endeffekt das Nutzsignal ohne Polumkehr den Eingang des Digitalfilters 9 erreicht. Die Polarität der Offset-Spannung der Anordnung 1 wird dagegen nur einmal, nämlich im Sigma-Delta-Modulator 8, periodisch umgepolt. Anlässlich einer ständigen Mittelwertbildung der Halbwellen im Digitalfilter 9 wird die Offset-Spannung mitsamt ihren Schwankungen und damit auch ihr Beitrag zum Ausgangssignal des Digitalfilters 9 vollständig eliminiert, wenn die Umschaltfrequenz der Polwender, d. h. die Frequenz des Taktsignals CL1, also z. B. 2⁵ Hz, ein ganzzahliges Vielfaches einer am Ausgang des Digitalfilters 9 vorhandenen Abtastfrequenz des Digitalfilters 9, z. B. 4 Hz, ist.

Dem Analog/Digital-Wandler 2 ist jeweils eine Anordnung 10 zur digitalen Quantisierung nachgeschaltet. Die leistungsproportionalen Ausgangssignale ±k.p[t] der Anordnung 1 werden mit Hilfe des Sigma-Delta-Modulators 8 in ein schnelles 1-Bit-Digitalsignal umgewandelt, welches seinerseits im Digitalfilter 9 in ein langsameres Mehrbit-Digitalsignal dezimiert wird unter gleichzeitiger Eliminierung vorhandener Störsignale, wie z. B. eine Modulation der leistungsproportionalen Ausgangssignale durch periodische Schwankungen der momentanen Leistung (doppelte Netzfrequenz), durch periodische Polaritätsumschaltungen (2⁵ Hz) der Offset-Spannung und durch eine ohmsche Nullkomponente des Hallelementes (Netzfrequenz). Da das Digitalfilter 9 synchron mit der Polaritätsumschaltung der Offset-Spannung arbeitet, ist die Unterdrückung der Modulation der Offset-Spannung fast ideal und jede Offsetspannung-Regelung überflüssig. Die Frequenz des schnellen 1-Bit-Digitalsignals beträgt z. B. 2¹⁷ Hz und diejenige des langsameren Mehrbit-Digitalsignals am Ausgang des Digitalfilters 9, wie bereits erwähnt, z. B. 4 Hz. Die in einem Integrationstakt von dann 4 Hz zur Verfügung stehenden digitalen Mehrbit-Ausgangswerte des Digitalfilters 9 sind dem über eine Integrationsperiode ermittelten Mittelwert der gemessenen Momentanleistung jeweils proportional. Die Verwendung der "Technologie der geschalteten Kapazitäten" ("Switched Capacitor Technology") gestattet es für den Sigma-Delta-Modulator 8 eine hohe Taktfrequenz zu verwenden, d. h. ein Taktsignal CLK der Frequenz 2¹⁷ Hz speist dessen Takteingang. Dies hat den Vorteil, dass eine geforderte Auflösung von z. B. 22 Bits des Analog/Digital-Wandlers 2 innerhalb einer sehr kurzen Zeit, z. B. innerhalb 0.5 Sekunde, erreicht werden kann. Diese hohe Auflösung wird erreicht einerseits dank der relativ hohen Abtastrate und anderseits dank der Verwendung eines Sinc²-Filters als Digitalfilter 9 anstelle eines Sinc-Filters. Die Kapazitäten aller Kondensatoren des Sigma-Delta-Modulators 8 können ausserdem so klein gewählt werden, dass sie alle intern in einem Chip realisierbar sind. Der Sigma-Delta-Modulator 8 in der Technologie der geschalteten Kapazitäten benötigt somit keine externe Kondensatoren.

Am Ausgang des Digitalfilters 9 und damit des Analog/Digital-Wandlers 2 sind digitalisierte Werte der über den Ausgabetakt des Digitalfilters 9 gemittelten Leistungssignale ±k.p[t] vorhanden, welche Werte nachfolgend abgekürzt digitale Leistungswerte genannt werden und z. B. 22-Bits an Auflösung besitzen. Diese digitalen Leistungswerte werden anschliessend in der Anordnung 10 quantisiert, d. h. fortwährend aufsummiert (akkumuliert) und in konstanten Quanten zerlegt. Jedesmal wenn die Summe im Akkumulator einen bestimmten Wert überschreitet, wird von der Summe eine konstante Zahl (Quantum) abgezogen und gleichzeitig am Ausgang der Anordnung 10 ein Ausgangsimpuls abgegeben. Diese Quanten sind durch den Kalibrationswert N_{K} einstellbar und entsprechen immer einem gleichen Wert der gemessenen Energie. Der Wert der Quanten und damit auch des Übertragungsfaktors der Anordnung 10, d. h. die Quantisierung, ist somit mittels des in einem unverlierbaren Speicher 11 gespeicherten Kalibrationswertes N_{K} einstell- und steuerbar. Ein unverlierbarer Speicher, auch nichtflüchtiger Speicher genannt, ist bekanntlich ein Speicher, der bei Spannungsausfall seinen Informationsinhalt nicht verliert. Ein Busausgang 11a des unverlierbaren Speichers 11 ist zu diesem Zweck über eine Busverbindung 11b mit einem ersten Buseingang 10a der Anordnung 10 verbunden (siehe Fig. 2 bis Fig. 5). Über die Programmierung des Übertragungsfaktors der Anordnung 10 kann die ganze erfindungsgemässe Anordnung digital kalibriert werden. Der unverlierbare Speicher 11 ist vorzugsweise ein feldprogrammierbarer Festwertspeicher FPROM ("Field programmable Read Only Memory") oder ein elektrisch programmierbarer Festwertspeicher EEPROM ("Electrical Erasable Programmable Read Only Memory").

In der in der Fig. 2 dargestellten ersten Variante einer ein einziges Messystem aufweisenden erfindungsgemässen Anordnung ist die Anordnung 10 zur digitalen Quantisierung ein Computer 12, vorzugsweise ein Mikrocomputer, der mit einer die digitale Quantisierung durchführenden Software versehen ist. Der unverlierbare Speicher 11 ist in diesem Fall vorzugsweise ein Teil der Computerspeicher. Ein serieller Ausgang des Digitalfilters 9 und damit des Analog/Digital-Wandlers 2 ist dann jeweils in vorteilhafter Weisc, in der angegebenen Reihenfolge, über eine Schnittstellen-Logik 13a und einer Schnittstellen-Busverbindung 13b mit einem zweiten Buseingang 10b der Anordnung 10, d. h. des Computers 12 verbunden. Die Schnittstellen-Logik 13a und die Schnittstellen-Busverbindung 13b bilden zusammen eine serielle Schnittstelle 13.

Eine in der Fig. 3 dargestellte erste Variante einer mehrere Messysteme aufweisenden erfindungsgemässen Anordnung besitzt pro Messystem je eine gleichaufgebaute Anordnung I bzw. II bzw. III. Es sind somit mehrere, z. B. drei, gleichaufgebaute Anordnungen I, II und III vorhanden, deren erstes Eingangssignal jeweils ein Wechselstrom i_{R}[t] bzw. i_{S}[t] bzw. i_{T}[t] und deren zweites Eingangssignal jeweils eine zu betreffenden Wechselstrom gehörige Wechselspannung u_{R}[t] bzw. u_{S}[t] bzw. u_{T}[t] ist. Die Anordnungen I bis III enthalten jeweils, in der angegebenen Reihenfolge, eine Reihenschaltung der Anordnung 1, des Analog/Digital-Wandlers 2 und der Schnittstellen-Logik 13a. Als Anordnung 10 zur digitalen Quantisierung ist vorzugsweise ein einziger für alle Messysteme gemeinsamer Computer, nämlich der Computer 12 vorhanden. Die Ausgänge der Anordnungen I, II und III sind dann über je eine Schnittstellen-Busverbindung 13b mit dem zweiten Buseingang 10b des gemeinsamen, die Funktion aller Anordnungen 10 übernehmenden Computers 12 verbunden. Der Ausgang des Analog/Digital-Wandlers 2 ist somit jeweils über eine serielle Schnittstelle 13 mit dem Computer 12 verbunden. Der letztere ist mit dem unverlierbaren Speicher 11 ausgerüstet und übernimmt die Quantisierung sowie Kalibration aller Messysteme sowie, bei Mehrphasen-Elektrizitätszählern, eine algebraische Addition der einzelnen Phasenleistungen oder Phasenenergien. Die algebraische Addition ist vorzugsweise ein additives bzw. subtraktives Zählen der Ausgangsimpulse aller Anordnungen I, II und III.

In der in der Fig. 4 dargestellten zweiten Variante einer ein einziges Messystem aufweisenden erfindungsgemässen Anordnung ist die Anordnung 10 zur digitalen Quantisierung ein digitaler Hardware-Quantisierer. Der serielle Ausgang des Digitalfilters 9 und damit des Analog/Digital-Wandlers 2 ist in diesem Fall vorzugsweise auf einen seriellen Eingang IN eines Serie/Parallel-Wandlers 14 geführt, dessen Parallel-Ausgang über eine Busverbindung 15 mit dem zweiten Buseingang 10b der Anordnung 10, d. h. des digitalen Hardware-Quantisierers verbunden ist. In der zweiten Variante ist der unverlierbare Speicher 11 vorzugsweise über eine serielle Kommunikations-Schnittstelle 16, die in der angegebenen Reihenfolge aus einer Kommunikations-Schnittstellenlogik 16a und einer Kommunikations-Schnittstellenbusverbindung 16b besteht, mit einem externen Computer 17 verbunden, unter anderem zum Laden des Kalibrationswertes N_{K} in den unverlierbaren Speicher 11. Der letztere ist somit vom Computer 17 über die serielle Kommunikations-Schnittstelle 16 programmierbar. Der externe Computer 17, der vorzugsweise ein Mikrocomputer ist, ist zu diesem Zweck während der Kalibrierung über die Kommunikations-Schnittstellenbusverbindung 16b mit der Kommunikations-Schnittstellenlogik 16a verbunden, die ihrerseits über eine Busverbindung 22 mit einem Buseingang des Speichers 11 verbunden ist. Die Anwesenheit der Kommunikations-Schnittstelle 16 in der zweiten Variante hat, ausser dem Laden oder Einbrennen des Kalibrationswertes N_{K} in den unverlierbaren Speicher 11, noch den Vorteil, dass mittels Befehle, die vom externen Computer 17 über die Kommnunikations-Schnittstelle 16 übertragen werden, auf verschiedene Testmodi umgeschaltet werden kann und ein Zugriff zu diversen Testsignalen möglich ist zwecks Verwirklichung z. B. eines erweiterten und/oder beschleunigten Tests. Der Serie/Parallel-Wandler 14 enthält ein in der Fig. 4 nicht dargestelltes Schieberegister, dessen serieller Ausgang einen seriellen Ausgang 14a des Serie/Parallel-Wandlers 14 bildet. Der serielle Ausgang 14a ist fakultativ über die Kommunikations-Schnittstellenlogik 16a und die Kommunikations-Schnittstellenbusverbindung 16b mit dem externen Computer 17 verbunden. Dies hat den Vorteil, dass die zweite Variante nachträglich leicht in eine abgewandelte zweite Variante umgewandelt werden kann, die ähnlich der ersten Variante ist, in der allerdings der externe Computer 17 und ein externer, nicht dargestellter unverlierbarer Speicher die Rolle des internen Computers 12, d. h. der internen Anordnung 10, und des internen Speichers 11 übernehmen. Die in der Fig. 4 dargestellten internen Bauelemente 10 und 11 sind dann überflüssig und laufen in diesem Fall nur im Leerlauf mit. Die erste und damit auch die abgewandelte zweite Variante haben den Vorteil, dass Probleme eliminiert werden können, die in Mehrphasen-Elektrizitätszählern durch einen durch Impulsaddition verursachten Jitter erzeugt werden.

In der in der Fig. 5 dargestellten abgewandelten zweiten Variante einer mehrere Messysteme aufweisenden erfindungsgemässen Anordnung sind wieder, gleich wie in der in der Fig. 3 dargestellten ersten Variante, mehrere, z. B. drei, gleichaufgebaute Anordnungen I, II und III mit ihren Eingangssignalen vorhanden. Die Anordnungen I bis III enthalten diesmal allerdings, in der angegebenen Reihenfolge, jeweils eine Reihenschaltung der Anordnung 1, des Analog/Digital-Wandlers 2, des Serie/Parallel-Wandlers 14 und, über den seriellen Ausgang 14a, der Kommunikations-Schnittstellenlogik 16a. Die Ausgänge der Anordnungen I, II und III sind über je eine Kommunikations-Schnittstellenbusverbindung 16b mit einem gleichen Buseingang 10b des gemeinsamen, die Funktion aller Anordnungen 10 übernehmenden Computers 12 bzw. 17 verbunden, wobei der letztere wieder mit einem unverlierbaren Speicher 11 ausgerüstet ist und die Quantisierung sowie Kalibration aller Messysteme und, bei Mehrphasen-Elektrizitätszählern, die algebraische Addition der einzelnen Phasenleistungen oder Phasenenergien übernimmt. Der Ausgang des Analog/Digital-Wandlers 2 ist somit in der abgewandelten zweiten Variante jeweils über den Serie/Parallel-Wandler 14 und die an dessen seriellen Ausgang 14a angeschlossene Kommunikations-Schnittstelle 16 mit dem Computer 12 bzw. 17 verbunden.

In der Fig. 3 und der Fig. 5 wurde das Taktsignal CL1 mit seinen Anschlüssen, obwohl vorhanden, aus Gründen der zeichnerischen Einfachheit nicht dargestellt. Wie aus diesen Figuren erkennbar, kann die Anordnung 10, wenn sie ein Computer 12 bzw. 17 ist, mit dem unverlierbaren Speicher 11 in Mehrsystem-Elektrizitätszählern zentral angeordnet werden. Dies hat unter anderem den Vorteil, dass beide nicht mehr zusammen mit den Bauelementen 1, 8, 9 und 13 oder 14 in jedem Sensorelement untergebracht werden müssen und somit die Kosten des Messystems stark reduziert werden können. Ein weiterer Vorteil der Computerlösungen der Anordnung 10 ist, dass der Kalibrationswert N_{K} im elektrisch reprogrammierbaren Festwertspeicher des Computers gespeichert ist und somit mehrmals geändert werden kann, so dass der betreffende Elektrizitätszähler mehrmals neu kalibrierbar ist.

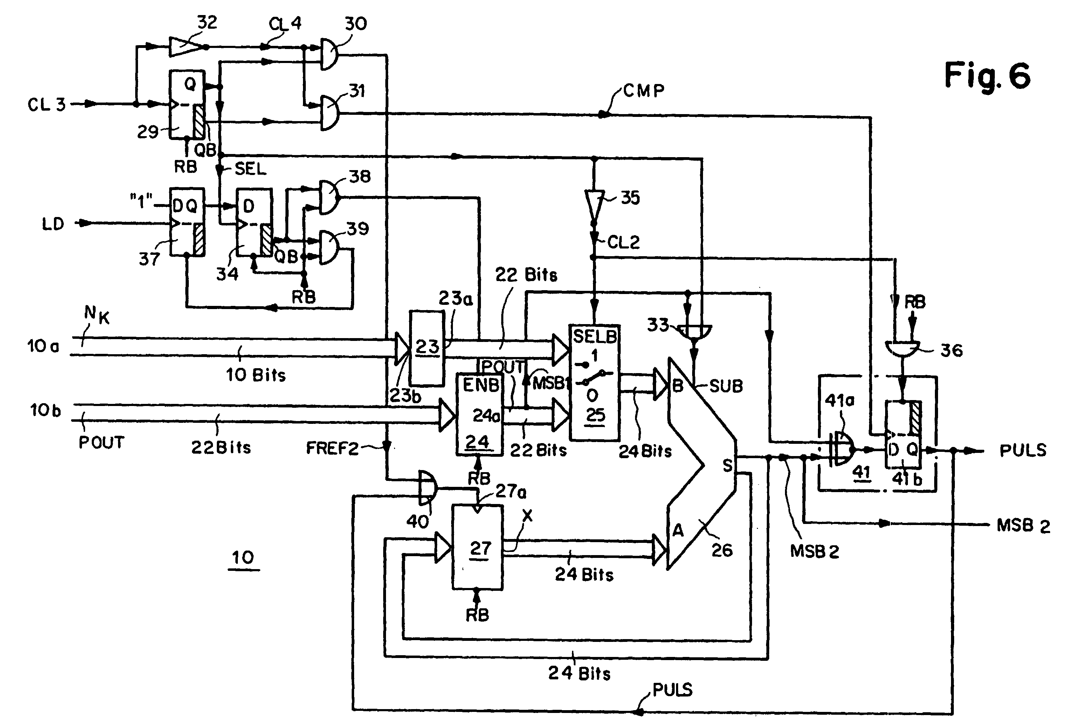

In der zweiten Variante (siehe Fig. 4) besitzt der digitale Hardware-Quantisierer, d. h. die Anordnung 10, vorzugsweise den in der Fig. 6 dargestellten Aufbau und enthält unter anderem eine Biterweiterung-Schaltung 23. Ein z. B. 22 Bits aufweisender Buseingang eines ersten Zwischenspeichers 24 bildet den zweiten Buseingang 10b des digitalen Hardware-Quantisierers. Der Zwischenspeicher 24 besitzt dann ebenfalls 22 Bits. Ein von einem Taktsignal CL2 gesteuerter Mehrbit-Umschalter 25 ist im Hardware-Quantisierer vorhanden zur zeitlich periodisch abwechselnden Verbindung eines ersten Buseingangs B eines algebraischen Addierers 26 mit einem Busausgang 24a bzw. 23a des ersten Zwischenspeichers 24 beziehungsweise der Biterweiterung-Schaltung 23. Der Busausgang 11a des Speichers 11 ist, wie bereits erwähnt, über die Busverbindung 11b mit dem ersten Buseingang 10a der Anordnung 10 und damit des Hardware-Quantisierers verbunden (siehe Fig. 4). Der Buseingang 10a ist seinerseits über eine z. B. 10 Bit-Busverbindung auf einen Buseingang 23b der Biterweiterung-Schaltung 23 geführt, so dass an den Buseingängen 10a und 23b der im unverlierbaren Speicher 11 gespeicherte 10 Bit-Kalibrationswert N_{K} ansteht. Der Busausgang 23a ist über eine 22 Bit-Busverbindung mit dem Mehrbit-Umschalter 25 verbunden. Am Ausgang 23a der Biterweiterung-Schaltung 23 steht der Wert einer 22 Bits aufweisenden Kalibrationskonstante N'_{K} = K_{A} + K_{B}.N_{K} an, wobei K_{A} und K_{B} zwei Konstanten sind. Der Kalibrationswert N_{K} ist der variable Anteil der Kalibrationskonstante N'_{K}. Um den Speicherbedarf der Kalibration zu minimieren wird im Speicher 11 nur der variable Anteil von N'_{K}, d. h. N_{K} gespeichert statt des gesamten Wertes von N'_{K}. Der nichtvariable Anteil von N'_{K} ist der Anordnung 10 bekannt und wird durch die Biterweiterung-Schaltung 23 berücksichtigt. Ein Busausgang S des algebraischen Addierers 26 ist mit einem Buseingang eines zweiten Zwischenspeichers 27 verbunden, dessen Busausgang auf einen zweiten Buseingang A des algebraischen Addierers 26 geführt ist. Der Mehrbit-Umschalter 25, der algebraische Addierer 26 und der zweite Zwischenspeicher 27 besitzen z. B. jeweils 24 Bits. Ein Taktsignal CL3, z. B. der Frequenz 2¹⁴ Hz, ist auf einen Takteingang eines Flip Flops 29 geführt, in dem seine Frequenz durch zwei geteilt wird, so dass zeitlich abwechselnd jeweils während 2⁻¹⁴ Sekunden ein Logikwert "1" am Q-Ausgang oder am invertierenden QB-Ausgang des Flip Flops 29 erscheint, um im ersteren Fall ein erstes Freigabe-Gatter 30 und im letzteren Fall ein zweites Freigabe-Gatter 31 für das in einem Inverter 32 invertierte Taktsignal CL3 freizugeben. Zu diesem Zweck ist der Q- und der QB-Ausgang des Flip Flops 29 jeweils mit einem ersten Eingang des Freigabe-Gatters 30 bzw. 31 verbunden. Das invertierte Taktsignal CL3 wird nachfolgend als Taktsignal CL4 bezeichnet und speist je einen zweiten Eingang der beiden Freigabe-Gatter 30 und 31, die beide z. B. Und-Gatter sind. Ein am Q-Ausgang des Flip Flops 29 anstehendes Signal ist mit SEL bezeichnet und speist einen ersten Eingang eines Nor-Gatters 33, einen Takteingang eines Flip Flops 34 und einen Eingang eines Inverters 35, dessen Ausgangssignal das Taktsignal CL2 ist. Das letztere speist einen Steuereingang SELB des Mehrbit-Umschalters 25, zwecks Umschaltung desselben, und einen ersten Eingang eines Und-Gatters 36. Ein Lade-Eingang LD des Hardware-Quantisierers ist auf einen Takteingang eines D-Flip Flops 37 geführt, an dessen D-Eingang ein Logikwert "1" ansteht und dessen Q-Ausgang auf einen D-Eingang des Flip Flops 34 geführt ist, dessen invertierender QB-Ausgang mit je einem ersten Eingang eines Nand-Gatters 38 und eines Und-Gatters 39 verbunden ist. Der Ausgang des letzteren ist aufeinen Rückstelleingang des Flip Flops 37 geführt. Der Ausgang des Nand-Gatters 38 ist mit einem invertierenden Lade-Eingang ENB des ersten Zwischenspeichers 24 verbunden. Ein am Lade-Eingang LD des Hardware-Quantisierers anstehendes Signal hat z. B. eine Frequenz von 4 Hz und seine steigende Flanke zeigt an, dass ein vom Analog/Digital-Wandler 2 seriell gelieferter Leistungswert am Parallelausgang des Serie/Parallel-Wandlers 14 als digitaler Leistungswert POUT ansteht, und veranlasst, dass ein Logikwert "1" in das Flip Flop 37 geladen wird. Das Q-Ausgangssignal des letzteren wird mittels des Signals SEL und des Flip Flops 34 synchronisiert, so dass das QB-Ausgangssignal des letzteren über das Nand-Gatter 38 den Ladevorgang des ersten Zwischenspeichers 24 und über das Und-Gatter 39 die Rückstellung des Flip Flops 37 auslöst, so dass im Endeffekt das Ausgangssignal des Nand-Gatters 38 ein Ladeimpuls ist, der veranlasst, dass der am Buseingang 10b anstehende und vom Parallelausgang des Serie/Parallel-Wandlers 14 herkommende digitale Leistungswert POUT in den ersten Zwischenspeicher 24 geladen wird. Das Freigabe-Gatter 30 ist im digitalen Hardware-Quantisierer vorhanden zum Laden, mittels des Taktsignals CL4, des Ausgangswertes des algebraischen Addierers 26 in den zweiten Zwischenspeicher 27, wenn der erste Buseingang B des algebraischen Addierers 26 mit dem Busausgang 24a des ersten Zwischenspeichers 24 verbunden ist, d. h. wenn der Q-Ausgang des Flip Flops 29 ein Logikwert "1" und das Taktsignal CL2 einen Logikwert "0"' besitzt. Zu diesem Zweck ist ein Ausgangssignal FREF2 des Freigabe-Gatters 30 über ein Oder-Gatter 40 und dessen ersten Eingang auf einen Lade-Eingang 27a des zweiten Zwischenspeichers 27 geführt. In diesem Fall arbeiten der Zwischenspeicher 24, der Mehrbit-Umschalter 25, der algebraische Addierer 26 und der Zwischenspeicher 27 zusammen als Akkumulator 24;25;26;27, in dem der im ersten Zwischenspeicher 24 gespeicherte digitale Leistungswert POUT algebraisch zu dem bereits im zweiten Zwischenspeicher 27 vorhandenen algebraischen Summenwert X algebraisch addiert wird. Da die digitalen Leistungswerte POUT in konstanten Zeitabständen von z. B. 2⁻² Sekunden am Buseingang 10b erscheinen und mit dem gleichen konstanten Zeitabstand in den Zwischenspeicher 24 geladen werden, ist, einmal von einem zu Beginn bereits vorhandenen Restwert abgesehen, der algebraische Summenwert X in der Zeit, während der die Anordnung 24,25;26;27 als Akkumulator arbeitet, gleich den während dieser Zeit akkumulierten Leistungswerten bzw., falls der konstante Zeitabstand 1 Sekunde beträgt, gleich der während dieser Zeit akkumulierten Energie. Bei einem von 1 Sekunde unterschiedlichen Zeitabstand ist der konstante Wert des letzteren in demjenigen des Kalibrationswertes N_{K} zu berücksichtigen. In der Zeit, während der der erste Buseingang B des algebraischen Addierers 26 mit dem Busausgang 23a der Biterweiterung-Schaltung 23 verbunden ist, d. h. wenn das Q-Ausgangssignal des Flip Flops 29 einen Logikwert "0" und das Taktsignal CL2 einen Logikwert "1" besitzt, ist der algebraische Addierer 26 bei einem im ersten Zwischenspeicher 24 gespeicherten negativen Wert POUT ein Additionsglied und bei einem dort gespeicherten positiven Wert POUT ein Subtraktionsglied. Im letzteren Fall ist der Ausgangswert des algebraischen Addierers 26 gleich der Differenz X-N'_{K} zwischen einem gerade im zweiten Zwischenspeicher 27 gespeicherten Wert X und dem am Busausgang 23a der Biterweiterung-Schaltung 23 anstehenden Wert der Kalibrationskonstante N'_{K}. Um dies zu erreichen, ist derjenige Ausgang des Busausgangs 24a des Zwischenspeichers 24, an dem das höchstwertigste Bit MSB1 ("most significant bit") ansteht, mit einem zweiten Eingang des Nor-Gatters 33 verbunden, dessen Ausgang auf einen Umschalteingang SUB des algebraischen Addierers 26 geführt ist. Falls das Ausgangssignal des Nor-Gatters 33 einen Logikwert "0" aufweist, arbeitet der algebraische Addierer 26 als Additionsglied und als Subtraktionsglied, wenn dieses Ausgangssignal einen Logikwert "1" besitzt. Mit anderen Worten, wenn während der erwähnten Zeit der Speicherwert POUT des Zwischenspeichers 24 positiv ist, erscheint der im Zwischenspeicher 27 gespeicherte akkumulierte Leistungswert X, reduziert um den Wert der Kalibrationskonstante N'_{K}, am Ausgang des algebraischen Addierers 26. Wenn dagegen während dieser Zeit der Speicherwert POUT des Zwischenspeichers 24 negativ ist, erscheint der im Zwischenspeicher 27 gespeicherte akkumulierte Leistungswert X, erhöht um den Wert der Kalibrationskonstante N'_{K}, am Ausgang des algebraischen Addierers 26. Diejenigen Ausgänge der Busausgänge 24a und S des ersten Zwischenspeichers 24 und des algebraischen Addieres 26, an denen jeweils das höchstwertigste Bit MSB1 bzw. MSB2 ansteht, sind mit je einem von zwei Eingängen eines nachgeschalteten Impulsgenerators 41 verbunden zwecks jeweiliger Erzeugung eines Impulses am Ausgang des letzteren, wenn zur Zeit, während der der erste Buseingang B des algebraischen Addierers 26 mit dem Busausgang 23a der Erweiterung-Schaltung 23 verbunden ist, beide höchstwertigste Bits MSB1 und MSB2 identisch sind. Jeder Ausgangsimpuls des Impulsgenerators 41 stellt dabei ein bestimmtes, durch den Kalibrationswert N_{K} vorgegebenes konstantes Quantum Energie dar. Mit anderen Worten: Während der erwähnten Zeit wird der im Zwischenspeicher 27 gespeicherte akkumulierte Leistungswert X mit dem Wert der Kalibrationskonstante N'_{K} verglichen. Ist der Speicherwert POUT des Zwischenspeichers 24 positiv, dann bildet der algebraische Addierer 26 die Differenz X-N'_{K} und ist diese Differenz positiv, d. h. ist X positiv und grösser als N'_{K}, dann erzeugt der Impulsgenerator 41 einen Impuls der Wertigkeit N'_{K}. Ist dagegen während dieser Zeit der Speicherwert POUT des Zwischenspeichers 24 negativ, dann bildet der algebraische Addierer 26 die Summe X+N'_{K} und ist diese Summe negativ, d. h. ist X negativ und im Absolutwert grösser als N'_{K}, dann erzeugt der Impulsgenerator 41 ebenfalls einen Impuls der Wertigkeit N'_{K}. Alle Ausgangsimpulse des Impulsgenerators 41 bilden zusammen ein Ausgangssignal PULS des Hardware-Quantisierers. Der Impulsgenerator 41 enthält z. B. ein Exklusiv-Nor-Gatter 41a, dessen beide Eingänge die beiden Eingänge des Impulsgenerators 41 bilden und dessen Ausgang mit einem D-Eingang eines D-Flip Flops 41b verbunden ist. Der Ausgang des Freigabe-Gatters 31 ist auf einen Takteingang des Flip Flops 41b geführt und speist diesen mit einem Signal CMP ("compare"). Der Ausgang des Und-Gatters 36 ist mit einem Rückstelleingang des Flip Flops 41b verbunden. Ein Q-Ausgang des Flip Flops 41b bildet den Ausgang des Impulsgenerators 41, der gleichzeitig ein erster Ausgang des Hardware-Quantisierers ist, an dem im Betrieb das Ausgangssignal PULS ansteht. Der Ausgang des Impulsgenerators 41 ist über das Oder-Gatter 40 und dessen zweiten Eingang mit dem Lade-Eingang 27a des zweiten Zwischenspeichers 27 verbunden. Mit anderen Worten, wenn ein Impuls am Ausgang des Impulsgenerators 41 erscheint, wird der Speicherwert X des Zwischenspeichers 27 durch den Wert X-N'_{K} bzw. -|X| +N'_{K} ersetzt, d. h. sein Absolutwert um den Energiewert N'_{K} des Ausgangsimpulses des Impulsezeugers 41 reduziert. Die durch die erfindungsgemässe Anordnung gemessene Energie besteht somit aus der Summe der Ausgangsimpulse des Impulsgenerators 41, die alle einen Energiewert N'_{K} darstellen, sowie aus einem im Zwischenspeicher 27 gespeicherten Restwert X-N'_{K} bzw. -|X| +N'_{K}, der noch mit dem Wert der Kalibrationskonstante N'_{K} zu wichten ist und erst im nächsten, am Ausgang des Impulsgenerators 41 erscheinende Impuls berücksichtigt wird. Derjenige Ausgang des Busausgangs S des algebraischen Addierers 26, an dem das höchstwertigste Bit MSB2 ansteht, bildet einen zweiten Ausgang des Hardware-Quantisierers, an dem jeweils ein Logikwert "1" ansteht, wenn der gerade am ersten Ausgang des Hardware-Quantisierers anstehende Impuls einer negativen Energie, und ein Logikwert "0", wenn dieser Impuls einer positiven Energie entspricht. Ein Rückstellsignal RB (d. h. "reset" invertiert) speist die zweiten Eingänge der Gatter 36, 38 und 39 sowie die Rückstelleingänge der Flip Flops 29 und 34 sowie der Zwischenspeicher 24 und 27 zur jeweiligen allgemeinen Rückstellung des Hardware-Quantisierers auf Null, wenn dies erforderlich ist.

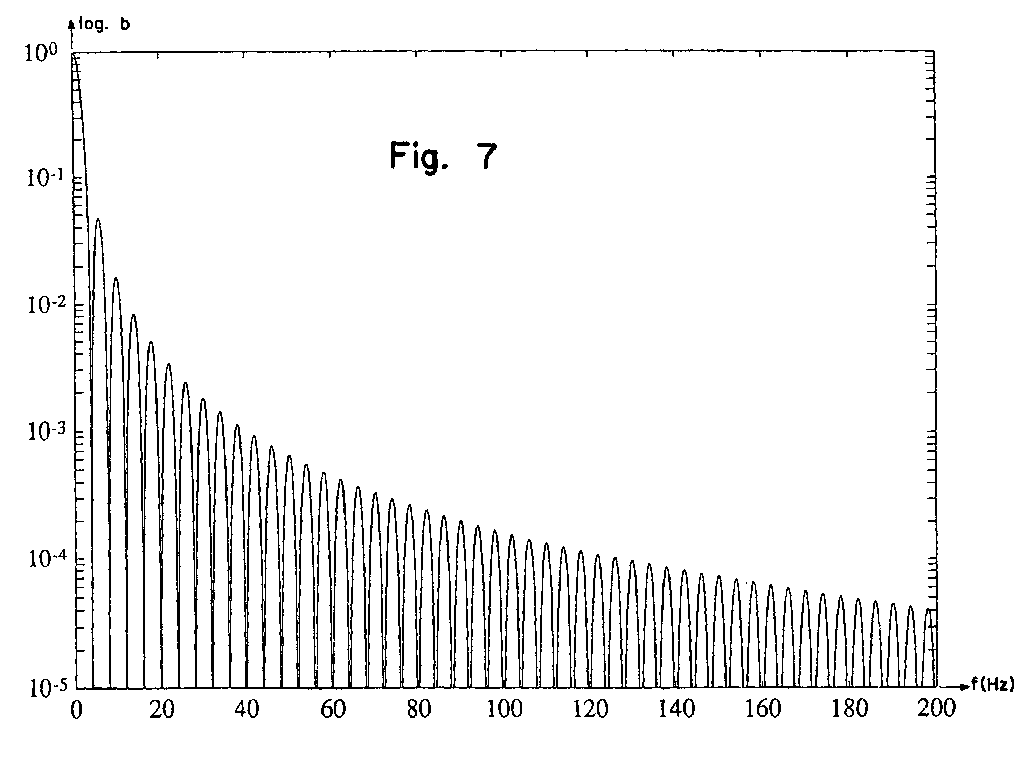

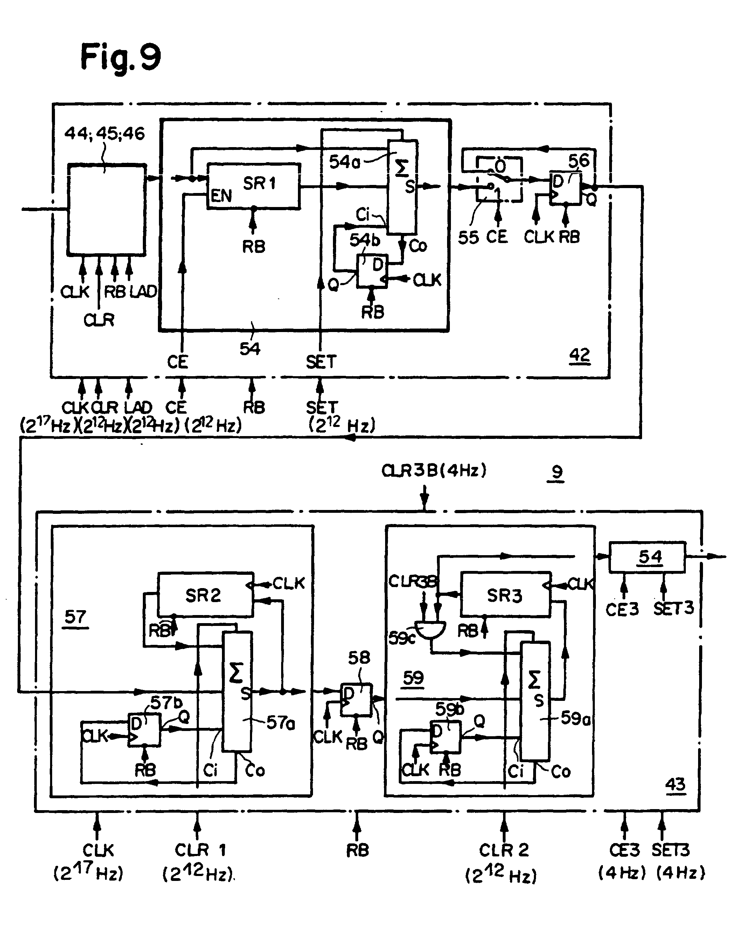

Das Digitalfilter 9 besitzt vorzugsweise eine ähnliche, wie die in der Fig. 7 dargestellte Dämpfungskennline. In der letzteren ist eine Filterdämpfung b logarithmisch in Funktion der Frequenz f dargestellt. Die Dämpfungskennlinie besitzt z. B. alle 4 Hz einen Dämpfungspol. Das Digitalfilter 9 enthält mindestens eine Filterstufe , deren Übertragungsfunktion mindestens zweiter Ordnung ist, d. h. es ist z. B. in vorteilhafter Weise ein Sinc^{K}-Filter mit K≥2. Da es mit der vorhandenen Taktfrequenz nicht immer möglich ist das ganze Digitalfilter 9 als seriell funktionierende Struktur aufzubauen, ist das Digitalfilter 9 in vorteilhafter Weise in zwei Stufen aufgeteilt und enthält somit, wenn die Filterstufe ein Sinc²-Filter ist, eine Reihenschaltung eines ersten Sinc²-Filters 42 und eines nachgeschalteten zweiten Sinc²-Filters 43 (siehe Fig. 9).

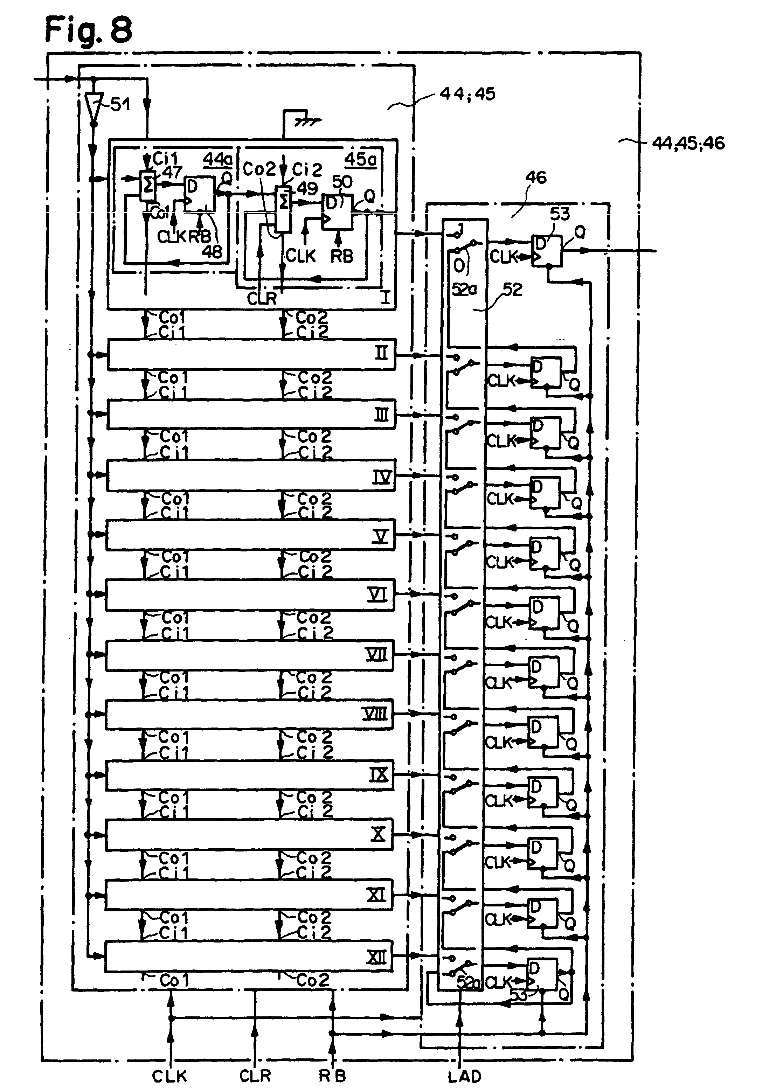

Das erste Sinc²-Filter 42 besitzt vorzugsweise 12 Bits. Wie aus der Fig. 9 ersichtlich enthält es am Eingang eine Anordnung 44;45;46, die ihrerseits , wie aus der Fig. 8 ersichtlich, am Eingang einen digitalen Doppelintegrator 44;45 enthält. Nach dem Doppelintegrator 44;45 ist in der Anordnung 44;45;46 eine in einem Dezimationsglied 46 durchgeführte Dezimation vorhanden. Um den Schaltungsaufwand und damit die benötigte Chipfläche möglichst gering zu halten, ist der Dezimationsfaktor des Sinc²-Filters 42, wenn dieses mindestens teilweise als Parallel-Schaltung ausgeführt ("implemented") ist, nur so gross wie unbedingt nötig gewählt, damit das nachfolgende Sinc²-Filter 43 vollständig als Serie-Schaltung aufgebaut werden kann. Das Sinc²-Filter 42 besitzt daher vorzugsweise einen Dezimationsfaktor-Wert 32 = 2⁵. Die Anordnung 44;45;46 kann als Parallel- oder als Serie-Schaltung ausgeführt werden. In der Fig. 8 gilt die Annahme, dass sie als Parallel-Schaltung ausgeführt ist und 12 Bits besitzt. In diesem Fall ist ein 1-Bit-Doppelintegrator pro Bit vorhanden, d. h. der Doppelintegrator 44;45 enthält in der Fig. 8 zwölf identisch aufgebaute 1-Bit-Doppelintegratoren I bis XII. Jeder 1-Bit-Doppelintegrator I bzw. II ... bzw. XII enthält einen ersten digitalen 1-Bit-Integrator 44a und einen in Reihe nachgeschalteten zweiten digitalen 1-Bit-Integrator 45a, welcher letzterer eine mittels eines externen Rückstellsignals CLR realisierte Rückstellung auf Null besitzt. In der Parallel-Ausführung bilden somit die zwölf 1-Bit-Integratoren 44a einen ersten digitalen Integrator 44 und die zwölf 1-Bit-Integratoren 45a einen dem Integrator 44 in Reihe nachgeschalteten zweiten digitalen Integrator 45. Ein Eingang des 1-Bit-Integrators 44a, der gleichzeitig ein Eingang des betreffenden 1-Bit-Doppelintegrators I bzw. II ... bzw. XII ist, ist jeweils durch einen ersten Eingang eines Addierers 47 gebildet, dessen Ausgang auf einen D-Eingang eines als Verzögerungsglied funktionierenden D-Flip Flops 48 geführt ist. Ein Q-Ausgang des letzteren bildet einerseits einen Ausgang des jeweiligen 1-Bit-Integrators 44a und ist anderseits auf einen zweiten Eingang des Addierers 47 geführt. Der Ausgang des ersten 1-Bit-Integrators 44a ist mit einem Eingang des zugehörigen zweiten 1-Bit-Integrators 45a verbunden, der einen Addierer 49 und ein D-Flip Flop 50 enthält. Der erste und der zweite 1-Bit-Integrator 44a und 45a sind ähnlich aufgebaut mit dem Unterschied, dass der Addierer 49 einen dritten Eingang besitzt zur Verwirklichung der Rückstellung mittels des externen Rückstellsignals CLR, welches den dritten Eingang aller zwölf Addierer 49 speist. Der Ausgang des zweiten 1-Bit-Integrators 45a ist jeweils auch ein von zwölf Ausgängen des Doppelintegrators 44;45 und auf einen zugehörigen von zwölf Eingängen des Dezimationsgliedes 46 geführt. Ein Eingang des Digitalfilters 9, der gleichzeitig ein Eingang der Anordnung 44;45;46 (siehe Fig. 9) und damit des Doppelintegrators 44;45 ist, ist über einen Inverter 51 mit den Eingängen der 1-Bit-Doppelintegratoren I bis XII verbunden, welche Eingänge somit parallel geschaltet sind. Der Eingang des Doppelintegrators 44;45 ist ausserdem unmittelbar mit einem Übertrags-Eingang Ci1 ("carry in") des Addierers 47 eines in der Reihenfolge ersten 1-Bit-Doppelintegrators I verbunden, während ein Übertrags-Eingang Ci2 des Addierers 49 des ersten 1-Bit-Doppelintegrators I an Masse liegt. Jeder Übertrags-Ausgang Co1 bzw. Co2 ("carry out") der Addierer 47 und 49 eines 1-Bit-Doppelintegrators I bzw. II ... bzw. XI ist mit einem Übertrags-Eingang Ci1 bzw. Ci2 des Addierers 47 bzw. 49 des in der Reihenfolge nachfolgenden Doppelintegrators II bzw. III ... bzw. XII verbunden, so dass die jeweiligen Übertrags-Ausgänge und Übertrags-Eingänge Co1 und Ci1 bzw. Co2 und Ci2 eine Kettenschaltung bilden. Die Übertrags-Ausgänge Co1 und Co2 des Addierers 47 bzw. 49 des in der Reihenfolge letzten 1-Bit-Doppelintegrators XII sind nirgendswo angeschlossen. Das Dezimationsglied 46 enthält pro Bit einen einpoligen Umschalter 52a und ein D-Flip Flop 53. Die zwölf einpolige Umschalter 52a bilden zusammen einen Mehrbit-Umschalter 52 und sind alle gleichzeitig mittels eines gemeinsamen periodischen LadeSignals LAD periodisch umschaltbar. Die Verbindungen zwischen den zwölf Umschaltern 52 und den zwölf D-Flip Flops 53 sind so, dass der D-Eingang eines jeden D-Flip Flops 53 periodisch abwechselnd mit dem zugehörigen Eingang des Dezimationsgliedes 46 und einem Q-Ausgang des in der Reihenfolge nachfolgenden D-Flip Flops 53 verbunden ist. Der Q-Ausgang des in der Reihenfolge letzten D-Flip Flops 53 wird im letzteren Fall durch den ihm zugehörigen einpoligen Umschalter 52a noch zusätzlich mit dem D-Eingang seines eigenen D-Flip Flops 53 verbunden. Wenn das Lade-Signal LAD einen Logikwert "1" besitzt, dann verbindet der Mehrbit-Umschalter 52 z. B. die zwölf Ausgänge des Doppelintegrators 44;45 mit den D-Eingängen der zwölf D-Flip Flops 53, so dass der gerade am Ausgang des ersteren anstehende 12-Bit-Wert parallel in die zwölf D-Flip Flops 53 geladen wird. Wenn das Lade-Signal LAD dagegen einen Logikwert "0" besitzt, dann verbindet der Mehrbit-Umschalter 52 die zwölf D-Flip Flops 53 in Reihe miteinander, so dass sie ein 12-Bit-Schieberegister bilden, dessen Ausgang ein Q-Ausgang des in der Reihenfolge ersten D-Flip Flops 53 ist, welcher Ausgang dann auch einen Ausgang des Dezimationsgliedes 46 sowie der Anordnung 44;45;46 bildet. Das Taktsignal CLK der Frequenz 2¹⁷ Hz speist die Takteingänge aller D-Flip Flops 48, 50 und 53. Das periodische Lade-Signal LAD, welches den Steuereingang des Mehrbit-Umschalters 52 speist, und das Rückstellsignal CLR besitzen beide eine gegenüber dem Taktsignal CLK um den Dezimationsfaktor verkleinerte Taktfrequenz, nämlich z. B. 2¹⁷/2⁵ Hz = 2¹² Hz, wenn der Dezimationsfaktor des Sinc²-Filters 42 einen Wert 32 = 2⁵ besitzt. D. h. alle 2⁻¹² Sekunden wird einerseits der zweite digitale Integrator 45 auf Null zurückgestellt und erscheint anderseits der Ausgangswert des Doppelintegrators 44;45 zeitseriell am Ausgang des Dezimationsgliedes 46. Die Rückstelleingänge der D-Flip Flops 48, 50 und 53 sind von einem gemeinsamen Rückstellsignal RB gespeist zwecks einer allgemeinen Rückstellung auf Null der Anordnung 44;45;46, wenn dies erforderlich ist.

Der Anordnung 44;45;46 und damit der Dezimation ist, wie in der Fig. 9 dargestellt, ein digitales Differentiationsglied 54 nachgeschaltet, so dass das erste Sinc²-Filter 42 den ersten digitalen Integrator 44, den nachgeschalteten zweiten digitalen Integrator 45, die nach dem letzteren vorhandene Dezimation sowie das der Dezimation nachgeschaltete digitale Differentiationsglied 54 enthält. Ein mittels eines Steuersignals CE gesteuerter einpoliger Umschalter 55 schaltet einen D-Eingang eines Synchronisations-Flip Flops 56 um vom Ausgang des Differentiationsgliedes 54, z. B. wenn das Steuersignal CE einen Logikwert "1" besitzt, auf einen Q-Ausgang des Synchronisations-Flip Flops 56, wenn das Steuersignal CE einen Logikwert "0" aufweist. Der letztere Q-Ausgang ist gleichzeitig ein Ausgang des ersten Sinc²-Filters 42. Das Differentiationsglied 54 kann als Parallel- oder Serie-Schaltung ausgeführt werden und besitzt im letzteren Fall den in der Fig. 9 dargestellten Aufbau. Es enthält in diesem Fall ein Schieberegister SR1, einen seriellen Addierer 54a und ein D-Flip Flop 54b. Wenn das erste Sinc²-Filter 42 ein 12 Bit-Filter ist, dann besitzt das Schieberegister SR1 ebenfalls 12 Bits. Ein Q-Ausgang des D- Flip Flops ist mit einem Übertrags-Eingang Ci ("carry in") des Addierers 54a verbunden, dessen Übertrags-Ausgang Co ("carry out") auf einen D-Eingang des D-Flip Flops 54b geführt ist. Ein serieller Eingang des Schieberegisters SR1 bildet einen Eingang des Differentiationsgliedes 54 und ist mit einem ersten Eingang des Addierers 54a verbunden, während ein serieller Ausgang des Schieberegisters SR1 auf einen zweiten Eingang des Addierers 54a geführt ist. Das Steuersignal CE speist einen Freigabe-Eingang EN ("enable") des Schieberegisters SR1, während das Rückstellsignal RB auf die Rückstelleingänge des Schieberegisters SR1 sowie der D-Flip Flops 54b und 56 geführt ist. Das Taktsignal CLK speist die Takteingänge der D-Flip Flops 54b und 56, während ein Setzsignal SET auf einen dritten Eingang des Addierers 54a geführt ist, dessen Ausgang S den Ausgang des Differentiationsgliedes 54 bildet.

Das zweite Sinc²-Filter 43 besitzt vorzugsweise 32 Bits. Wie in der Fig. 9 dargestellt enthält es einen ersten digitalen Integrator 57 und einen über ein Synchronisations-Flip Flop 58 nachgeschalteten zweiten digitalen Integrator 59, welcher letzterer eine mittels eines Rückstellsignals CLR2 realisierte Rückstellung auf Null besitzt. Nach dem zweiten digitalen Integrator 59 ist wieder eine Dezimation vorhanden, der ein weiteres digitales Differentiationsglied 54 nachgeschaltet ist, welches den gleichen inneren Aufbau besitzt wie das Differentiationsglied 54 des ersten Sinc²-Filters 42, mit dem einzigen Unterschied, dass das Schieberegister SR1 diesmal, genau wie nachfolgend erwähnte Schieberegister SR2 und SR3, jeweils ein 32-Bit-Schieberegister ist, wenn das zweite Sinc²-Filter 43 ein 32-Bit-Filter ist. Das letztere Filter besitzt vorzugsweise einen Dezimationsfaktor Wert 1024 = 2¹⁰. Die Integratoren 57 und 59 sowie das Differentiationsglied 54 können wieder als Parallel- oder Serie-Schaltung ausgeführt werden. Letzteres wurde in der Fig. 9 angenommen. In diesem Fall enthält der erste Integrator 57 das Schieberegister SR2, einen seriellen Addierer 57a und ein D-Flip Flop 57b, während der zweite Integrator 59 das Schieberegister SR3, einen seriellen Addierer 59a, ein D-Flip Flop 59b und ein Und-Gatter 59c enthält. Ein Q-Ausgang des D-Flip Flops 57b ist mit einem Übertrags-Eingang Ci ("carry in") des Addierers 57a verbunden, dessen Übertrags-Ausgang Co ("carry out") auf einen D-Eingang des D-Flip Flops 57b geführt ist. Ein erster Eingang des Addierers 57a bildet einen Eingang des ersten Integrators 57 und damit auch des zweiten Sinc²-Filters 43. Ein Ausgang S des Addierers 57a bildet einen Ausgang des ersten Integrators 57 und ist ausserdem mit einem seriellen Eingang des Schieberegisters SR2 verbunden, dessen serieller Ausgang auf einen zweiten Eingang des Addierers 57a geführt ist. Der Ausgang des ersten Integrators 57 ist mit einem D-Eingang des Synchronisations-Flip Flops 58 verbunden, dessen Q-Ausgang auf einen Eingang des zweiten Integrators 59 geführt ist. Ein Q-Ausgang des D-Flip Flops 59b ist mit einem Übertrags-Eingang Ci ("carry in") des Addierers 59a verbunden, dessen Übertrags-Ausgang Co ("carry out") auf einen D-Eingang des D-Flip Flops 59b geführt ist. Ein erster Eingang des Addierers 59a bildet den Eingang des zweiten Integrators 59. Ein Ausgang S des Addierers 59a ist mit einem seriellen-Eingang des Schieberegisters SR3 verbunden, dessen serieller Ausgang einen Ausgang des zweiten Integrators 59 bildet und zusätzlich mit einem ersten Eingang des Und-Gatters 59c verbunden ist, dessen Ausgang auf einen zweiten Eingang des Addierers 59a geführt ist. Der Ausgang des zweiten Integrators 59 ist mit einem Eingang des Differentiationsgliedes 54 des zweiten Sinc²-Filters 43 verbunden, dessen Ausgang einen Ausgang des zweiten Sinc²-Filters 43 und damit des Digitalfilters 9 bildet. Das Taktsignal CLK und das Rückstellsignal RB speisen die Takteingänge bzw. die Rückstelleingänge der Flip Flops 57b, 58 und 59b sowie der Schieberegister SR2 und SR3, während ein Rückstellsignal CLR1 und das Rückstellsignal CLR2 jeweils auf einen dritten Eingang des Addierers 57a bzw. des Addierers 59a geführt sind. Die Frequenz der Rückstellsignale CLR1 und CLR2 ist z. B. 2¹⁷/2⁵ = 2¹² Hz. Ein Rückstellsignal CLR3B (d. h. "clear 3" invertiert) speist einen zweiten Eingang des Und-Gatters 59c, während ein Signal CE3 den Freigabeeingang EN des im Differentiationsglied 54 des Sinc²-Filters 43 enthaltenen Schieberegisters SR1 speist. Ein Signal SET3 speist dagegen den dritten Eingang des dort enthaltenen Addierers 54a. Das Signal CE3 veranlasst am Eingang des Differentiationsgliedes 54 des Sinc²-Filters 43 die Dezimation, da seine Frequenz genau wie diejenigen der Signale CLR3B und SET3 gleich der um den Dezimationsfaktor des Sinc²-Filters 43 reduzierte Frequenz 2¹² Hz des Signals LAD ist, d.h. gleich 2¹²/2¹⁰ Hz = 4 Hz ist, wenn der Dezimationsfaktor des Sinc²-Filters 43 den Wert 2¹⁰ = 1024 besitzt.

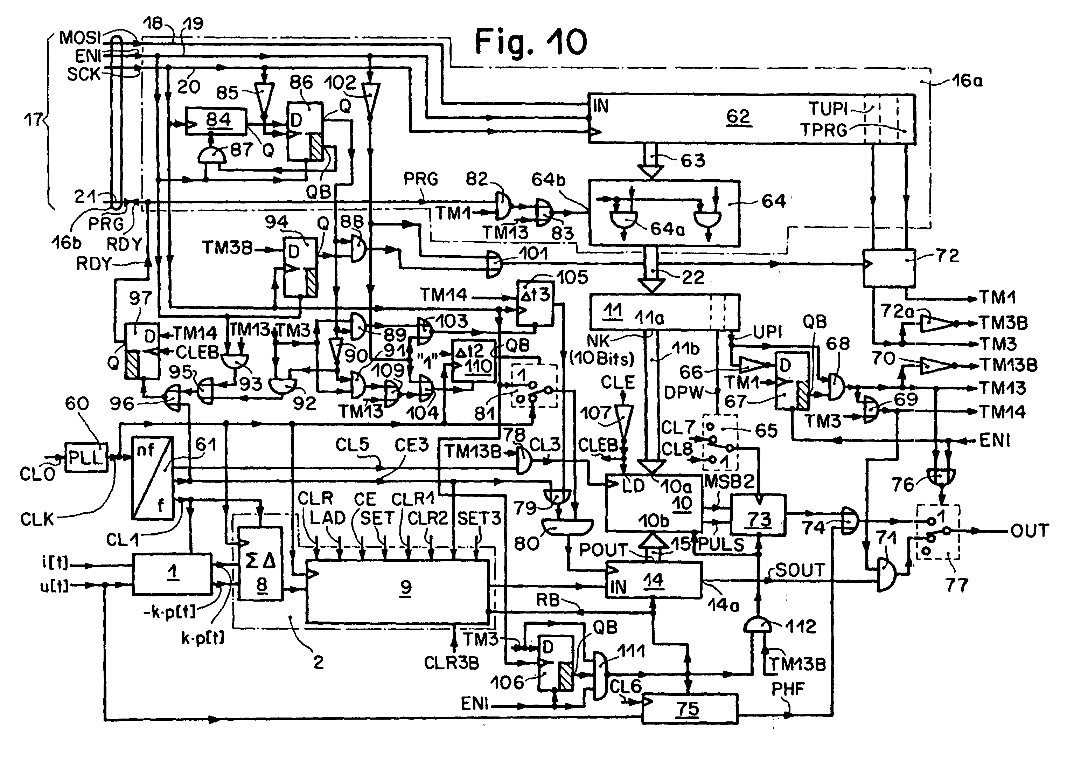

In der Fig. 10 ist die zweite erfindungsgemässe Variante und damit die in der Fig. 4 dargestellte erfindungsgemässe Anordnung ohne den externen Computer 17 ausführlich dargestellt. Die Fig. 10 zeigt einen Phasenregelkreis 60 (PLL: "phase locked loop"), dessen Eingang von einem Taktsignal CL0 gespeist ist, welches z. B. eine Frequenz 2¹³Hz aufweist. Diese Frequenz wird im Phasenregelkreis 60 mit einem Faktor von z. B. 2⁴ multipliziert, so dass an dessen Ausgang ein synchrones Taktsignal CLK der Frequenz 2¹⁷ Hz erscheint, welche Frequenz anschliessend in einem Frequenzteiler 61 geteilt wird zwecks Ereugung verschiedener Takt- und Rückstellsignale, die dann an je einem Ausgang des Frequenzteilers 61 erscheinen. In der Fig 10 sind aus Gründen der zeichnerischen Klarheit nur drei Ausgänge dargestellt, an denen das Taktsignal CL1 der Frequenz 2⁵ Hz bzw. das Signal CE3 der Frequenz 4 Hz bzw. ein Taktsignal CL5 der Frequenz 2¹⁴ Hz ansteht. Es ist jedoch wohlverstanden, dass die Signale CLR1 (2¹⁶ Hz), CLR2 (2¹⁵ Hz), CLR (2¹² Hz), LAD (2¹² Hz), CE (2¹² Hz), SET (2¹² Hz), CL6 (2¹¹ Hz), SET3 (4 Hz), CLR3B (4 Hz), CLE (4 Hz) und CLEB (d. h. CLE invertiert: 4 Hz) im Frequenzteiler 61 durch Frequenzteilung erzeugt werden, welche notfalls von einer Synchronisation und/oder einer Verzögerung mittels D-Flip Flops gefolgt ist, um anschliessend an die Schaltung weitergeleitet zu werden. Die Taktsignale Signale CL7 (2¹³ Hz) und CL8 (2¹² Hz) werden dagegen unmittelbar vom Taktsignal CL0 abgeleitet. Der externe Computer 17 speist, wie bereits erwähnt, über die Kommunikations-Schnittstellenbusverbindung 16b die Kommunikations-Schnittstellenlogik 16a (siehe Fig. 4). Die Kommunikations-Schnittstelle 16 ist vorzugsweise eine standardisierte synchrone serielle Schnittstelle. In der Kommunikations-Schnittstellenbusverbindung 16b sind in diesem Fall mindestens drei Leiter vorhanden, wobei über einen Leiter 18 ein Signal MOSI, über einen Leiter 20 ein Schnittstellen-Taktsignal SCK und über einen dritten Leiter ein Signal MISO übertragen wird. MOSI bedeutet "Master out, slave in", während MISO "Master in, slave out" bedeutet, wobei der Computer 17 jeweils der "Master"-Computer und die erfindungsgemässe Anordnung der "Slave" ist. Für Mehr-Messystem-Anwendungen ist noch ein vierter Leiter 19 in der Kommunikations-Schnittstellenbusverbindung 16b vorhanden zur Übertragung eines Schnittstellen-Freigabesignals ENI ("Enable Interface"), welches im richtigen Zeitpunkt nur eines der Messysteme, d. h. dessen Signale MISO und SCK freigibt, so dass die Messysteme sich gegenseitig nicht behindern können. Für das Einlesen von Informationen in den Computer 17 ist in der Kommunikations-Schnittstellenbusverbindung 16b noch ein fünfter Leiter 21 vorhanden, an dem jeweils ein Betriebsbereit-Signal RDY ("ready") ansteht, welches von der Kommunikations-Schnittstelle 16 zum Computer 17 übertragen wird. Die fünften Leiter aller Messysteme einer Mehr-Messystem-Anordnung sind entweder über eine sogenannte "Wired or"-Verknüpfung mit einem "Interrupt"-Eingang des Computers 17 verbunden oder individuell an separaten Eingängen des letzteren angeschlossen. Über den Leiter 21 kann auch ein Programmierimpuls PRG vom Computer 17 zur Kommunikations-Schnittstelle 16 übertragen werden. Über die Leiter 18 bis 21 wird somit je eines der vier Signale MOSI bzw. ENI bzw. SCK bzw. PRG vom Computer 17 zur erfindungsgemässen Anordnung übertragen, während das Signal RDY in umgekehrter Richtung von der letzteren zum Computer 17 übertragen wird. Die Kommunikations-Schnittstellenlogik 16a enthält ein Schieberegister 62. Der Computer 17 speist über den Leiter 18 einen seriellen Eingang IN des Schieberegisters 62 mit dem Signal MOSI, über den Leiter 19 einen Rückstelleingang des Schiebereregisters 62 mit dem Signal ENI und über den Leiter 20 einen Takteingang des Schieberegisters 62 mit dem Taktsignal SCK. Das Schieberegister 62 besitzt mindestens soviele Bits wie der Kalibrationswert N_{K} Anzahl Bits aufweist, z. B. 10 Bits. In der Fig. 10 gilt die Annahme, dass das Schieberegister 62 mindestens noch vier weitere Bits besitzt, nämlich:
- ein Bit DPW, welches einen Logikwert "1" besitzt, wenn die Ausgangsimpulse der Variante 2 eine doppelte Impulslänge besitzen sollen,
- ein Bit UPI, welches einen Logikwert "1"' besitzt, wenn die zweite Variante als abgewandelte zweite Variante arbeiten soll,
- ein Bit TUPI, welches einen Logikwert "1" besitzt, wenn die abgewandelte zweite Variante getestet werden soll, und
- ein Bit TPRG, welches einen Logikwert "1" besitzt, wenn der Kalibrationswert N_{K} der zweiten Variante programmiert werden soll.

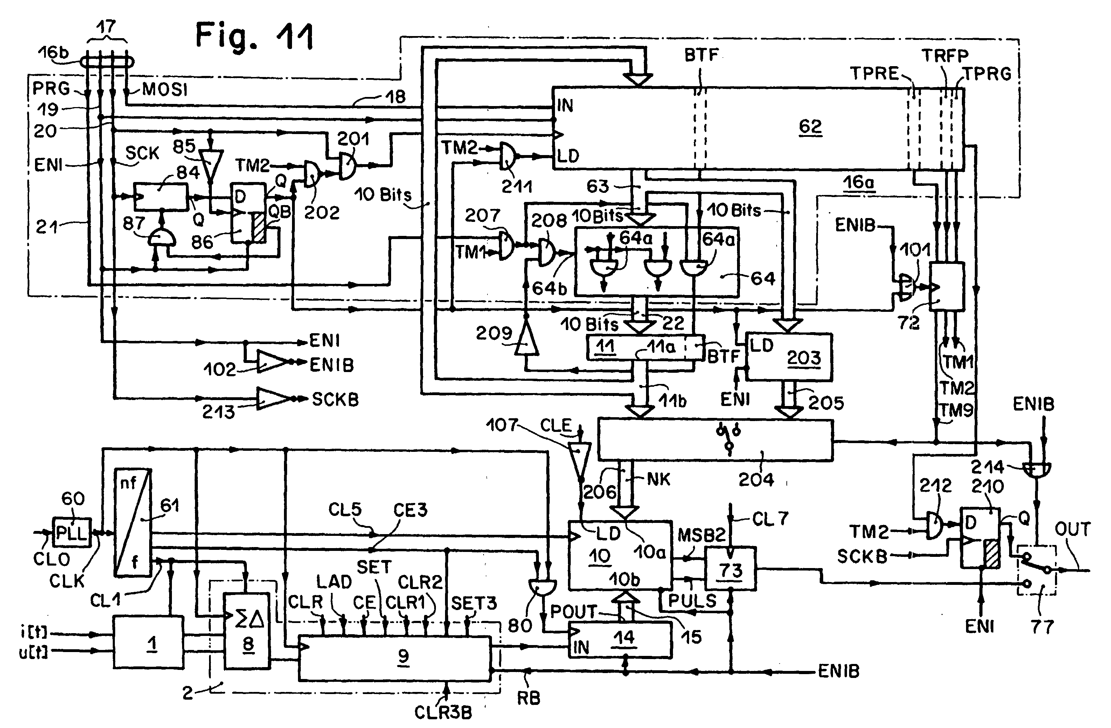

Die serielle Kommunikations-Schnittstelle 16 ist ein Empfänger und Speicher für die seitens des Computers 17 anlässlich einer Programmierung und/oder eines Tests ausgesandten Bitwerte eines zum Kalibrationswert N_{K} in Beziehung stehenden Kodewortes sowie der zusätzlichen Bits DPW, UPI, TUPI und TPRG, zu denen in der in der Fig. 11 dargestellten Anordnung noch mindestens drei weitere zusätzliche Bits TRFP, TPRE und BTF hinzukommen. Das zum Kalibrationswert N_{K} in Beziehung stehende Kodewort ist entweder der Kalibrationswert N_{K} selber oder ein Pseudo-Kalibrationswert, der später noch erläutert wird. Der Programmierimpuls PRG dazu dient, mit Hilfe eines der empfangenen zusätzlichen Bits, nämlich TPRG, das mit dem Kalibrationswert N_{K} in Beziehung stehende Kodewort in den unverlierbaren Speicher 11 zu speichern. Das Schieberegister 62 dient einem zeitseriellen Speichern der vom Computer 17 ausgesandten Bitwerte des Kalibrationswertes N_{K} bzw. des Pseudo-Kalibrationswertes sowie der Bits DPW, UPI, TUPI, TPRG, TRFP, TPRE und BTF. Die zu den vom Computer 17 ausgesandten Bitwerten gehörenden Bits besitzen vorzugsweise die Gestalt des über den Leiter 18 der Kommunikations-Schnittstellenbusverbindung 16b übertragenen zeitseriellen Signals MOSI. Die zu den 10 Bits des Kalibrationswertes N_{K} gehörenden Ausgänge sowie die beiden zu den Bits UPI und DPW gehörenden Ausgänge des Schieberegisters 62, also total zwölf Ausgänge, sind über eine Busverbindung 63 mit ersten Eingängen von ebensovielen Freigabe-Gattern 64a einer Programmierungs-Freigabeanordnung 64 der Kommunikations-Schnittstellenlogik 16a verbunden. Zweite Eingänge der Freigabe-Gatter 64a, die z. B. Und-Gatter sind, bilden, alle miteinander verbunden, einen Programmier-Eingang 64b der Programmierungs-Freigabeanordnung 64. Die Ausgänge der Freigabe-Gatter 64a sind über die Busverbindung 22 mit einem Buseingang des unverlierbaren Speichers 11 verbunden. Die zu den zehn Bits des Kalibrationswertes N_{K} gehörenden Ausgänge 11a des unverlierbaren Speichers 11 sind über die Busverbindung 11b mit dem ersten Buseingang 10a der Anordnung 10 verbunden, welche in der zweiten Variante, wie bereits erwähnt, ein digitaler Hardware-Quantisierer ist. Die Programmierungs-Freigabeanordnung 64 dient der Weiterleitung mindestens eines Teils der im Schieberegister 62 gespeicherten Bitwerte, nämlich derjenigen von N_{K} (bzw. von Pseudo-Kalibrationwerten), von DPW und von UPI (sowie von BTF: Siehe Fig. 11) an den unverlierbaren Speicher 11 zwecks dortiger Speicherung.

Ein zum Bit DPW gehörender Ausgang des unverlierbaren Speichers 11 ist auf einen Steuereingang eines einpoligen Umschalters 65 geführt. Ein zum Bit UPI gehörender Ausgang des unverlierbaren Speichers 11 ist über einen Inverter 66 auf einen D-Eingang eines D-Flip Flops 67 und unmittelbar auf einen ersten Eingang eines Und-Gatters 68 geführt, an dessen Ausgang ein Signal TM13 ansteht, welches seinerseits auf einen ersten Eingang eines Oder-Gatters 69 und auf einen Eingang eines Inverters 70 geführt ist. Am Ausgang des letzteren steht ein Signal TM13B, d. h. TM13 invertiert, an, während am Ausgang des Oder-Gatters 69 ein Signal TM14 ansteht, welches auf einen ersten Eingang eines Und-Gatters 71 geführt ist, dessen zweiter Eingang mit dem seriellen Ausgang 14a des Serie/Parallel-Wandlers 14 verbunden ist. Ein zum Bit TUPI gehörender Ausgang des Schieberegisters 62 ist auf einen Eingang einer zugehörigen Speicherzelle eines Hilfsspeichers 72 geführt, an deren Ausgang ein Signal TM3 ansteht, welches einen zweiten Eingang des Oder-Gatters 69 speist. Der Hilfsspeicher 72 besteht z. B. aus Flip Flops. Das Signal TM3 wird in einem Inverter 72a invertiert zwecks Erhalt des Signals TM3B. Ein zum Bit TPRG gehörender Ausgang des Schieberegisters 62 ist auf einen Eingang einer zugehörigen Speicherzelle des Hilfsspeichers 72 geführt, an deren Ausgang ein Signal TM1 ansteht, welches einen Takteingang des D-Flip Flops 67 speist, dessen QB-Ausgang mit einem zweiten Eingang des Und-Gatters 68 verbunden ist. Der Hilfsspeicher 72 dient somit jeweils der Speicherung eines weiteren Teils der im Schieberegister 62 gespeicherten Bitwerte, nämlich derjenigen der Bits TUPI und TPRG (sowie TRFP und TPRE gemäss Fig. 11).

Die beiden Ausgangssignale PULS und MSB2 der Anordnung 10 speisen je einen getrennten Eingang eines Impulsgenerators 73, dessen Takteingang mittels des einpoligen Umschalters 65 entweder auf das Taktsignal CL7 der Frequenz 2¹³ Hz, wenn das Bit DPW einen Logikwert "0" besitzt, oder auf das Taktsignal CL8 der Frequenz 2¹² Hz umgeschaltet wird, wenn das Bit DPW einen Logikwert "1" besitzt. Dadurch wird die Zeitbasis des Impulsgenerators 73 umgeschaltet und zwar verdoppelt. Im Impulsgenerator 73 werden Impulse erzeugt, deren Längen vom positiven oder negativen Vorzeichen der ermittelten Energie abhängig sind, d. h. wenn ein Impuls des Signals PULS zu einer positiven Energie gehört (MSB2 = "0"), dann wird am Ausgang des Impulsgenerators 73 ein Impuls der Länge 122µs und, wenn er zu einer negativen Energie (MSB2 = "1") gehört, der Länge 61 µs erzeugt, falls das Taktsignal CL7 als Zeitbasis aktiv ist. Wenn dagegen das Taktsignal CL8 als Zeitbasis aktiv ist, sind die entsprechenden Werte 244µs und 122µs, also doppelt so gross. Der Ausgang des Impulsgenerators 73 ist mit einem ersten Eingang eines Oder-Gatters 74 verbunden. Die Wechselspannung u[t] ist auf einen Eingang einer Spannungs-Überwachungsschaltung 75 geführt, dessen Takteingang vom Taktsignal CL6 gespeist ist und an dessen Ausgang bei Unterschreitung eines Mindestwertes der Spannung u[t] ein Impuls der Länge 488µs als Spannungsausfall-Signal PHF ("phase fail") erzeugt wird, welches dann auf einen zweiten Eingang des Oder-Gatters 74 geführt ist. Das Signal TM13 ist auf einen ersten Eingang und das Signal ENI auf einen zweiten Eingang eines Nor-Gatters 76 geführt, dessen Ausgang mit einem Steuereingang eines einpoligen Umschalters 77 verbunden ist. Der letztere schaltet einen Ausgang OUT der erfindungsgemässen Anordnung um von einem Ausgang des Und-Gatters 71 auf einen Ausgang des Oder-Gatters 74. Um Mehr-Messystem-Anwendungen zu ermöglichen ist der Ausgang OUT vorzugsweise ein "Tri state"-Ausgang. Das Taktsignal CL5 ist auf einen ersten Eingang eines Und-Gatters 78 geführt, an dessen zweiten Eingang das Signal TM13B ansteht und dessen Ausgangssignal das Taktsignal CL3 der Frequenz 2¹⁴ Hz ist, welches einen Takteingang der Anordnung 10 speist. Das Signal CE3 der Frequenz 4 Hz speist einen ersten Eingang eines Oder-Gatters 79, dessen Ausgang mit einem ersten Eingang eines Und-Gatters 80 verbunden ist, dessen Ausgang seinerseits auf einen Takteingang des Serie/Parallel-Wandlers 14 geführt ist. Ein zweiter Eingang des Und-Gatters 80 ist mittels eines einpoligen Umschalters 81 entweder mit dem Taktsignal CLK der Frequenz 2¹⁷ Hz oder mit dem Taktsignal SCK verbunden. Der Computer 17 speist über den Leiter 21 einen ersten Eingang eines Nand-Gatters 82 mit dem Programmier-Signal PRG. Das Signal TM1 speist einen zweiten Eingang des Nand-Gatters 82, dessen Ausgang auf einen ersten Eingang eines Nor-Gatter 83 geführt ist, an dessen zweiten Eingang das Signal TM 13 ansteht und dessen Ausgang mit dem Programmier-Eingang 64b der Programmierungs-Freigabeanordnung 64 verbunden ist. Das Taktsignal SCK ist mit einem Takteingang eines Zählers 84 und über einen Inverter 85 mit einem Takteingang eines D-Flip Flops 86 verbunden. Ein serieller Q-Ausgang des Zählers 84 ist auf einen D-Eingang des D-Flip Flops 86 geführt, dessen QB-Ausgang mit einem ersten Eingang eines Und-Gatters 87 verbunden ist, an dessen zweiten Eingang das Signal ENI ansteht und dessen Ausgang auf einen Rückstelleingang des Zählers 84 geführt ist. Ein Q-Ausgang des D-Flip Flops 86 ist mit je einem ersten Eingang zweier Und-Gatter 88 und 89 sowie über einen Inverter 90 mit je einem ersten Eingang zweier Und-Gatter 91 und 92 verbunden. An zweite Eingänge der Und-Gatter 89, 91 und 92 steht das Signal TM3 an, während an einem ersten Eingang eines Und-Gatters 93 das Signal TM13 ansteht. Das Signal ENI speist einen zweiten Eingang des Und-Gatters 93 und einen Rückstelleingang eines D-Flip Flops 94, an dessen D-Eingang das Signal TM3B und an dessen Takteingang das Taktsignal SCK ansteht, während sein Q-Ausgang mit einem zweiten Eingang des Und-Gatters 88 verbunden ist. Je ein Ausgang der Und-Gatter 92 und 93 ist auf je einen Eingang eines Oder-Gatters 95 geführt, dessen Ausgang mit einem ersten Eingang eines Nor-Gatters 96 verbunden ist. Das Signal CE3 speist einen zweiten Eingang des letzteren, während sein Ausgang auf einen Rückstelleingang eines D-Flip Flops 97 geführt ist, an dessen D-Eingang das Signal TM14 und an dessen Takteingang das Signal CLEB ansteht. An einem Q-Ausgang des D-Flip Flops 97, der mit dem Leiter 21 verbunden ist, erscheint ein Signal RDY, welches vorzugsweise ein "Tri state"-Signal ist, damit es durch einen möglicherweise gleichzeitig am Leiter 21 erscheinenden Programmierimpuls PRG nicht gestört und/oder überschrieben wird. Ein Ausgang des Und-Gatters 88 ist auf einen ersten Eingang eines Oder-Gatters 101 geführt, dessen Ausgang mit einem Takteingang des Hilfsspeichers 72 verbunden ist. Das Signal ENI speist über einen Inverter 102 einen zweiten Eingang des Oder-Gatters 101 sowie je einen ersten Eingang eines Nor-Gatters 103 und eines Oder-Gatters 104. Ein Ausgang des Und-Gatters 89 ist mit einem zweiten Eingang des Nor-Gatters 103 verbunden, dessen Ausgang aufeinen Rückstelleingang eines Zeitverzögerungsgliedes 105 geführt ist, an dessen Eingang das Signal TM14 ansteht und dessen Ausgang mit einem zweiten Eingang des Oder-Gatters 79 verbunden ist. Das Taktsignal SCK speist je einen Takteingang des Zeitverzögerungsgliedes 105 und eines D-Flip Flops 106, während das Signal CLE über einen Inverter 107 den Lade-Eingang LD der Anordnung 10 speist. Ein Ausgang des Und-Gatters 91 ist auf einen ersten Eingang eines Nor-Gatters 109 geführt, an dessen zweiten Eingang das Signal TM13 ansteht und dessen Ausgang mit einem zweiten Eingang des Oder-Gatters 104 verbunden ist. Ein Ausgang des letzteren ist auf einen Rückstelleingang eines Zeitverzögerungsgliedes 110 geführt, an dessen Eingang ein Logikwert "1" und an dessen Takteingang das Taktsignal CLK ansteht, während sein QB-Ausgang mit einem Steuereingang des einpoligen Umschalters 81 verbunden ist. Das Signal TM3 speist einen D-Eingang des D-Flip Flops 106 und einen ersten Eingang eines Nand-Gatters 111, dessen zweiter Eingang mit einem QB-Ausgang des D-Flip Flops 106 verbunden ist, während sein Ausgang auf einen ersten Eingang eines Und-Gatters 112 und auf je einen Rückstelleingang des Digitalfilters 9, des Serie/Parallel-Wandlers 14 und der Spannungs-Überwachungsschaltung 75 geführt ist, wobei das Rückstellsignal am Rückstelleingang des Digitalfilters 9 mit RB bezeichnet ist. An einem zweiten Eingang des Und-Gatters 112 steht das Signal TM13B an, während sein Ausgang mit je einem Rückstelleingang der Anordnung 10 und des Impulsgenerators 73 verbunden ist. Das Signal ENI speist einen dritten Eingang des Nand-Gatters 111 und je einen Rückstelleingang der D-Flip Flops 67, 86 und 106.

Die in der Fig. 11 dargestellte Ausführung der zweiten Variante entspricht annähernd, unter Weglassung von Details, der in der Fig. 10 dargestellten Ausführung mit den nachfolgenden Änderungen bzw. Ergänzungen. Das Signal CL5 ist unmittelbar auf den Takteingang der Anordnung 10 und die Signale CE3 sowie CLK sind unmittelbar auf je einen Eingang des Und-Gatters 80 geführt, dessen Ausgang mit dem Takteingang des Serie/Parallel-Wandlers 14 verbunden ist. Die Kommunikations-Schnittstelle 16 empfängt und speichert zusätzlich noch die Bitwerte der Bits TRFP, TPRE und BTF, die anlässlich einer Kalibrierung und/oder eines Tests als Signal MOSI vom Computer 17 über die Kommunikations-Schnittstellenbusverbindung 16b zur erfindungsgemässen Anordnung übertragen werden. Das Signal MOSI wird dabei wieder in das Schieberegister 62 hineingeschoben, welches diesmal dem zeitseriellen Zwischenspeichern des Bitwerte von N_{K}, TPRG, TRFP, TPRE und BTF dient. Das Schieberegister 62 besitzt somit mindestens soviele Bit-Speicherzellen, wie N_{K} Anzahl Bits aufweist, z. B. 10 Bits, plus vier Bits, total vierzehn. Nachfolgend gilt die Annahme, dass das Schieberegister 62 gesamthaft 32 Bits aufweist, damit zusätzlich zu den vierzehn Bits noch weitere übertragene Bits, unter anderem das nicht dargestellte Bit TUPI (siehe Fig. 10), gespeichert werden können. Das Bit TRFP ist ein Lese-Bit, das Bit TPRE ein Kontroll-Bit und das Bit BTF ein Sperr-Bit. Wenn N_{K} zehn Bits aufweist, dann sind z. B. die letzten zehn Bits des Signals MOSI die zehn Bits des Kalibrationswertes N_{K}, während z. B. das erste Bit des Signals MOSI das Bit TPRG, das zweite Bit das Lese-Bit TRFP, das neunte Bit das Kontroll-Bit TPRE und das elft:-letzte Bit das Sperr-Bit BTF ist. Das Bit TPRG besitzt wieder einen Logikwert "1", wenn der Kalibrationswert N_{K} anlässlich der Kalibration im unverlierbaren Speicher 11 gespeichert werden soll. Das Lese-Bit TRFP besitzt einen Logikwert "1", wenn der Inhalt des unverlierbaren Speichers 11 zu Kontrollzwecken gelesen werden soll, z. B. bevor er endgültig definitif gemacht wird. Das Kontroll-Bit TPRE besitzt einen Logikwert "1", wenn, ohne Abspeicherung im unverlierbaren Speicher 11, getestet werden soll, ob der berechnete Wert von N_{K} korrekt ist. Das Sperr-Bit BTF besitzt einen Logikwert "1", wenn der Wert N_{K} definitif im unverlierbaren Speicher 11 gespeichert ist und unwiderruflich endgültig gemacht werden soll. In der Fig. 11 speist das Schnittstellen-Taktsignal SCK über einen ersten Eingang eines Und-Gatters 201 den Takteingang des Schieberegisters 62. Der Q-Ausgang des D-Flip Flops 86 ist mit einem ersten Eingang eines Nand-Gatters 202 verbunden, an dessen zweiten Eingang ein Signal TM2 ansteht, während sein Ausgang mit einem zweiten Eingang des Und-Gatters 201 verbunden ist.

Die zehn zu den zehn Bits des Kalibrationswertes N_{K} gehörende Parallelausgänge des Schieberegisters 62 sind über die Busverbindung 63 nicht nur mit dem Buseingang der Programmierungs-Freigabeanordnung 64 verbunden, sondern auch mit einem Buseingang eines weiteren Hilfsspeichers 203. Ein Mehrbit-Umschalter 204 ist vorhanden zwecks eines Umschaltens des Buseinganges 10a der Anordnung 10 vom Busausgang 11a des unverlierbaren Speichers 11 auf einen Busausgang des weiteren Hilfsspeichers 203. Zu diesem Zweck ist ein Busausgang des weiteren Hilfsspeichers über eine Busverbindung 205 auf zehn erste Eingänge des Mehrbit-Umschalters 204 geführt, während der Ausgang des unverlierbaren Speichers 11 über die Busverbindung 11b mit zehn zweiten Eingängen des Mehrbit-Umschalters 204 verbunden ist, dessen Ausgang über eine Busverbindung 206 auf den Buseingang 10a der Anordnung 10 geführt ist. Ausserdem ist der Ausgang des unverlierbaren Speichers 11 über die Busverbindung 11b mit einem Paralleleingang der zehn zum Kalibrationswert N_{K} gehörenden Speicherzellen des Schieberegisters 62 verbunden zwecks Rückspeicherung des Inhaltes N_{K} des unverlierbaren Speichers 11 in das Schieberegister 62, dessen Inhalt dann zum Computer 17 übertragbar ist zwecks dortigem Lesen des Inhaltes N_{K} des unverlierbaren Speichers 11. Die Programmierungs-Freigabeanordnung 64 enthält diesmal ein Freigabe-Gatter 64a mehr als N_{K} Anzahl Bits aufweist, nämlich ein Freigabe-Gatter 64a für eine zugehörige Speicherzelle des unverlierbaren Speichers 11 zwecks dortigem Speichern des vom Computer 17 über die Kommunikations-Schnittstelle 16 übertragenen und im Schieberegister 62 zwischengespeicherten Sperr-Bits BTF. Ein zum Bit BTF gehörender Parallelausgang des Schieberegisters 62 ist mit einem ersten Eingang dieses zusätzlichen Freigabe-Gatters 64a der Programmierungs-Freigabeanordnung 64 verbunden, dessen zweiter Eingang mit einem Ausgang eines Und-Gatters 207 und einem ersten Eingang eines Sperr-Gatters 208 verbunden ist, während sein Ausgang mit einem Eingang der zusätzlichen zugehörigen Speicherzelle des unverlierbaren Speichers 11 verbunden ist. Das Sperr-Gatter 208 ist ein Und-Gatter. Der Ausgang der betreffenden Speicherzelle des unverlierbaren Speichers 11 ist über einen Inverter 209 mit einem zweiten Eingang des Sperr-Gatters 208 verbunden zwecks Sperrung der anderen Freigabe-Gatter 64a der Programmierungs-Freigabeanordnung 64. Zu diesem Zweck ist der Ausgang des Sperr-Gatters 208 mit dem Programmier-Eingang 64b der Programmierungs-Freigabeanordnung 64 verbunden. Die letztere dient somit der Weiterleitung der Werte der zehn Bits von N_{K} sowie desjenigen des Sperr-Bits BTF an den unverlierbaren Speicher 11 zwecks dortiger Speicherung. Der Computer 17 speist über die Drahtverbindung 21 einen ersten Eingang des Und-Gatters 207 mit dem Programmierimpuls PRG. Am zweiten Eingang des Und-Gatters 207 liegt das Signal TM1. Das Signal ENI speist je einen Rückstelleingang des Hilfsspeichers 203 und eines D-Flip Flops 210. Der Q-Ausgang des D-Flip Flops 86 ist mit einem Ladeeingang LD des Hilfsspeichers 203 und je einem Eingang eines Nand-Gatters 211 sowie des Oder-Gatters 101 verbunden. Das Signal ENIB speist je einen Rückstelleingang des Digitalfilters 9, des Serie/Parallel-Wandlers 14, der Anordnung 10 und des Impulsgenerators 73. An einem zweiten Eingang des Nand-Gatters 211 steht das Signal TM2 an, während sein Ausgang mit einem Lade-Eingang LD des Schieberegisters 62 verbunden ist. Ein serieller Ausgang des letzteren ist auf einen ersten Eingang eines Und-Gatters 212 geführt, an dessen zweiten Eingang das Signal TM2 liegt und dessen Ausgang mit einem D-Eingang des D-Flip Flops 210 verbunden ist. Ein Takteingang des letzteren wird über einen Inverter 213 vom Schnittstellen-Taktsignal SCK gespeist. Zu den Bits TRFP und TPRE gehörende Ausgänge des Schieberegisters 62 sind auf je einen Eingang einer zugehörigen Speicherzelle des Hilfsspeichers 72 geführt, an deren Ausgänge jeweils das Signal TM2 bzw. ein Signal TM9 ansteht. Ein zum letzteren und damit zum Kontroll-Bit TPRE gehörender Ausgang des Hilfsspeichers 72 ist auf einen Steuereingang des Mehrbit-Umschalters 204 und auf einen ersten Eingang eines Oder-Gatters 214 geführt, an dessen zweiten Eingang das Signal ENIB liegt, während sein Ausgang mit einem Steuereingang des einpoligen Umschalters 77 verbunden ist. Der letztere schaltet entweder einen Q-Ausgang des D-Flip Flops 210 oder den Ausgang des Impulsgenerators 73 auf den Ausgang OUT der erfindungsgemässen Anordnung.

Die in den Figuren 10 und 11 dargestellte Anordnung arbeitet folgendermassen:

Vor jedem Verfahrens-Modus besitzt das Signal ENI, welches vom Computer 17 der erfindungsgemässen Anordnung über den Leiter 19 zugeleitet wird, einen Logikwert "0", welcher die Bauelemente 84, 86, 94 und 62 auf Null zurückgestellt bzw. Nullwerte aus dem zurückgestellten Schieberegister 62 in den lilftspeicher 72 lädt, so dass auch der letztere auf Null zurückgestellt ist und seine Ausgangssignale TM 1 und TM3 beide Null sind. Zu Beginn eines Verfahrens-Modus setzt der Computer 17 das Signal ENI jeweils auf Logikwert "1", wodurch die Bauelemente 62, 86 und 94 freigegegeben werden und der Zählvorgang des Zählers 84 gestartet wird. Der letztere zählt ab Startaugenblick die Perioden des vom Computer 17 über den Leiter 20 gesandten Taktsignals SCK, welches, sobald das Schieberegister 62 freigegeben ist, das vom Computer 17 über den Leiter 18 gesandte Signal MOSI in das Schieberegister 62 hineinschiebt, wo dessen Bits gespeichert werden. Nachfolgend gilt die Annahme, dass das Signal MOSI und das Schieberegister 62 je 32 Bits besitzen. Der Zähler 84 zählt dann bis 32. Bei der 31-ten steigenden Flanke des Taktsignals SCK erscheint ein Logikwert "1" am Q-Ausgang des Zählers 84, welcher Logikwert mit Hilfe des Inverters 85 bei der 32-ten fallenden Flanke des Taktsignals SCK in das D-Flip Flop 86 geladen wird. Das QB-Ausgangssignal des letzteren stellt dann über das Und-Gatter 87 den Zähler 84 auf Null zurück, worauf um eine Periode des Taktsignals SCK verzögert wieder ein Logikwert "0" in das D-Flip Flop 86 geladen wird. Mit anderen Worten: Bei der 32-ten fallenden Flanke des Taktsignals SCK, d. h. wenn 31 Bits des Signals MOSI in das Schieberegister 62 hineingeschoben und dort gespeichert sind, erscheint ein Impuls am Q-Ausgang des D-Flip Flops 86. Dieser Impuls erreicht über die Gatter 88 und 101 (siehe Fig. 10) bzw. über das Gatter 101 (siehe Fihg. 11) den Takteingang des Hilfsspeichers 72, wo er veranlasst, dass ein Teil der im Schieberegister 62 gespeicherten Bits des Signals MOSI in die ihnen zugehörigen Speicherzellen des Hilfsspeichers 72 gespeichert werden.

Am Ende eines jeden Verfahrens-Modus beendet der Computer 17 den Modus, indem er das Signal ENI auf Null zurückschaltet, wodurch die erfindungsgemässe Anordnung auf Null zurückgestellt wird bzw. Nullwerte in den Hilfsspeicher 72 geladen werden, so dass die Ausgangssignale TM1, TM2, TM3 und TM9 des letzteren alle wieder Null sind.

Vor einer ersten Inbetriebnahme der zweiten Variante muss der Kalibrationswert N_{K} programmiert werden, d. h. sein digitaler Wert muss als Teil des Signals MOSI zeitseriell vom Computer 17 über den Leiter 18 zur erfindungsgemässen Anordung, d. h. zu deren Kommunikations-Schnittstelle 16 übertragen und anschliessend im Speicher 11 gespeichert werden. Nachfolgend gilt die Annahme, dass die letzten zehn Bits des Signals MOSI die zehn Bits des Kalibrationswertes N_{K} sind. Im Programmier-Modus besitzt das erste Bit TPRG des Signals MOSI einen Logikwert "1", das dritte und zwölft-letzte Bit TUPI bzw. UPI je einen Logikwert Null sowie das elft-letzte Bit DPW einen beliebigen Logikwert. Die Logikwerte der Signale TM3, TM13 und TM14 sind und bleiben während des ganzen Programmier-Modus Null, da die beiden zugehörigen Bits UPI und TUPI gleich Null sind. Die Signale TM3B und TM13B besitzen somit während des ganzen Programmier-Modus einen Logikwert "1". Sobald das Bit TPRG im Hilfsspeicher 72 gespeichert ist, nimmt das Signal TM1 einen Logikwert "1" an, welcher das Gatter 82 bzw. 207 freigibt. Ein vom Computer 17 anschliessend über den Leiter 21 gesandter kurzer Programmierimpuls PRG, z. B. der Dauer 10µs, erreicht über die Gatter 82 und 83 bzw. 207 und 208 den Programmier-Eingang 64b der Programmier-Freigabeanordnung 64, wodurch die angeschlossenen Freigabe-Gatter 64a für die Dauer des Programmierimpulses freigegeben werden. Dadurch werden die Bits UPI und DPW sowie die zehn Bits des Kalibrationswertes N_{K} in den Speicher 11 geladen, von wo die letzteren zehn Bits über die Busverbindung 11b an den Buseingang 10a der Anordnung 10 weitergeleitet werden. Da während des Programmier-Modus das Signal ENI gleich Eins ist, besitzt das Ausgangssignal des Nor-Gatters 76 (siehe Fig. 10) einen Logikwert "0", so dass der Ausgang OUT der erfindungsgemässen Anordnung über den Umschalter 77 mit dem Ausgang des durch das Signal TM 14 gesperrten Und-Gatters 71 verbunden ist, so dass kein eine Energie darstellender Impuls den Ausgang OUT erreicht. Nach Beendigung des Programmier-Modus wird das Signal TM 1 durch die allgemeine Rückstellung wieder Null und das Gatter 82 bzw. 207 wieder für jeden weiteren Programmierimpuls PRG gesperrt. Anschliessend kann der Computer 17 entfernt und die erfindungsgemässe Anordnung auf Lager gelegt und/oder verkauft werden.

Der Speicher 11 ist vorzugsweise ein feldprogrammierbarer Festwertspeicher FPROM ("field programable read only memory"), dessen Speicherzellen z. B. je eine Diode oder Zenerdiode aufweisen und normalerweise, d. h. bei vorhandener Diode bzw. Zenerdiode, z. B. je einen Logikwert "0" enthalten. Zu diesem Zweck sind die Dioden bzw. Zenerdioden derart mit einer äusseren Beschaltung versehen, dass, wenn sie vorhanden sind, je ein Logikwert "0" am Ausgang der betreffenden Speicherzellen erscheint. Wenn in einer Speicherzelle dagegen ein Logikwert "1" zu speichern ist, muss beim Programmieren mittels eines Stromimpulses durch Überstrom die Diode bzw. Zenerdiode der betreffenden Speicherzelle zerstört, d. h. durchgebrannt werden, so dass diese praktisch nicht mehr vorhanden ist. Das Laden des Speichers 11 erfolgt in diesem Fall somit durch Einbrennen. Bei nicht mehr vorhandener Diode bzw. Zenerdiode erscheint durch deren weiterhin vorhandene äussere Beschaltung ein Logikwert "1" am Ausgang der betreffenden Speicherzelle. Ist jetzt ein digitaler Kalibrationswert N_{K}, der in der Regel mehrere Bitwerte "0" und "1" enthält, im Speicher 11 zu speichern, so können anlässlich des Programmierens alle dessen Speicherzellen, in denen ein Bitwert '"0" zu speichern ist, unverändert bleiben, da der Logikwert "0" bereits im voraus in ihnen abgespeichert worden ist durch die Anwesenheit der zugehörigen Dioden bzw. Zenerdioden. Alle Speicherzellen, in denen ein Bitwert "1" zu speichern ist, müssen dagegen programmiert, d. h. deren Dioden bzw. Zenerdioden durch einen Stromimpuls zerstört werden. In einer ersten Variante des erfindungsgemässen Verfahrens werden alle Bitwerte "1" des Kalibrationswertes N_{K} mittels eines einzigen Programmierzyklus gleichzeitig geladen, d. h. gleichzeitig eingebrannt. Wenn dagegen viele Bitwerte "1" zu speichern und somit viele Dioden bzw. Zenerdioden zu zerstören sind, benötigt ein gleichzeitiges Laden aller Bitwerte "1" des Kalibrationswertes N_{K} einen sehr grossen Stromimpuls, d. h. bis zu 100 mA pro Bitwert "1", der in der Regel nicht zur Verfügung steht. Daher werden in einer zweiten Variante des erfindungsgemässen Verfahrens alle Bitwerte "1" des Kalibrationswertes N_{K} vorzugsweise jeder für sich getrennt und zeitlich hintereinander mittels eines eigenen Programmierzyklus im Speicher 35 abgespeichert. Im Programmier-Modus werden dann zeitlich nacheinander soviele Programmierzyklen durchlaufen, wie Bitwerte des leeren Speichers 11 durch Kalibrieren geändert werden müssen. In diesen Programmierzyklen werden jeweils zusätzlich zu einem unterschiedlichen digitalen Pseudo-Kalibrationswert das Zusatz-Bit TPRG, das Schnittstellen Taktsignal SCK, das Freigabesignal ENI und der Programmierimpuls PRG vom Computer 17 über die Kommunikations-Schnittstelle 16 der Anordnung zugeführt, wo während eines jeden Programmierzyklus das Zusatz-Bit TPRG in den Hilfsspeicher 72 sowie der betreffende digitale Pseudo-Kalibrationswert N_{K} mit Hilfe des im Hilfsspeicher 72 gespeicherten Zusatz-Bits TPRG und des Programmierimpulses PRG in den Speicher 11 gespeichert werden. Dabei ist ein digitaler Pseudo-Kalibrationswert jeweils der digitale Kalibrationswert N_{K}, in dem, ausser einem, alle Bitwerte, die im leeren Speicher 11 geändert werden müssen, durch einen Bitwert des leeren Speichers 11 ersetzt worden sind. Wenn der leere Speicher 11 also Bitwerte "Null" enthält, dann müssen die in ihm durch das Kalibrieren zu ändernde Bitwerte nach dem Kalibrieren je einen Bitwert "Eins" besitzen. Dementsprechend werden soviele Programmierzyklen durchlaufen, wie Bitwerte "Eins'' im Kalibrationswert N_{K} enthalten sind und ein digitaler Pseudo-Kalibrationswert ist dann jeweils der zu speichernde digitale Kalibrationswert N_{K}, in dem, ausser einem, alle Bitwerte "Eins" durch einen Bitwert "Null" ersetzt worden sind. In jedem Programmierzyklus wird dann ein einziger Bitwert "1" des Kalibrationswertes N_{K} in den Speicher 11 abgespeichert, d. h. eingebrannt. Zu diesem Zweck ist das betreffende Bit der zehn letzten, zum Kalibrationswert N_{K} gehörenden Bits des vom Computer 17 gesandten Signals MOSI gleich Logikwert "1", während die anderen neun dieser zehn Bits je einen Logikwert "0" besitzen. Da nur ein einziges Bit von N_{K} einen Bitwert "1" besitzt, erscheint auch nur ein einziger Logikwert "1"' an den Ausgängen der Programmier-Freigabeanordnung 64. Es wird somit nur eine einzige Speicherzelle des Speichers 11 programmiert.

Der Eingang der erfindungsgemässen Anordnung, an dem das Signal ENI ansteht, ist mit Hilfe eines sogenannten "Pull up"-Widerstandes so verdrahtet, dass nach Abtrennung des Computers 17 im Normalbetrieb ein Signal ENIB (d. h. ENI invertiert) gleich Eins und damit das Signal ENI gleich Null ist, so das die Bauelemente 16, 67, 72, 84, 86 und 94 ausser Betrieb bzw. auf Null zurückgestellt sind. Die Signale TM1, TM3, TM13 und TM14 besitzen somit je einen Logikwert Null, während die Signale TM3B und TM13B je einen Logikwert "1" aufweisen. Dadurch ist unter anderem das Und-Gatter 78 freigegeben (siehe Fig. 10), so dass das Taktsignal CL5 als Taktsignal CL3 den Takteingang der Anordnung 10 erreicht. Ausserdem erscheint, durch das Zeitverzögerungsglied 110 um eine Zeit Δt2 verzögert, ein Logikwert "0" am QB-Ausgang des Zeitverzögerungsgliedes 110, so dass der Umschalter 81 das Taktsignal CLK auf einen Eingang des Und-Gatters 80 schaltet, was zur Folge hat, dass während der Dauer der Impulse des 4Hz-Signals CE3, welches über das Oder-Gatter 79 den anderen Eingang des Und-Gatters 80 erreicht, das Taktsignal CLK den Takteingang des Serie/Parallel-Wandlers 14 speist. Der digitale Hardware-Quantisierer mit seinem, während des Programmier-Modus im Speicher 11 gespeicherten Kalibrationswert N_{K} und der Impulsgenerator 73 sind in Betrieb, so dass die die ermittelte Energie darstellenden Impulse am Ausgang des letzteren erscheinen. Da die beiden Signale ENI und TM13 Null sind, steht ein Logikwert "1" am Ausgang des Nor-Gatters 76 an, welcher den Umschalter 77 umschaltet, so dass die Ausgangsimpulse des Impulsgenerators 73 über das Oder-Gatter 74 und den umgeschalteten Umschalter 77 den Ausgang OUT der erfindungsgemässen Anordnung erreichen. Mit anderen Worten: Die Bauelemente 1, 8, 9, 10, 11, 14, 60, 61, 65, 73, 74, 75, 76, 77, 78, 79, 80, 81, 102, 104, 110 und 112 werden benötigt. Der während des Programmier-Modus im Speicher 11 gespeicherte Wert des Bits DPW bestimmt die Position des Umschalters 65 und damit den Wert der Zeitbasis 2¹³ Hz bzw. 2¹² Hz des Impulsgenerators 73, so dass die Ausgangsimpulse des letzteren und damit diejenigen der erfindungsgemässen Anordnung je nach Logikwert "0" oder "1" des Bits DPW eine einfache bzw. doppelte Impulslänge besitzen.

Vor einer Inbetriebnahme der abgewandelten zweiten Variante muss ein Logikwert "1" des Bits UPI in den unverliebaren Speicher 11 gespeichert werden. Diese Programmierung des Bits UP1 geschieht in einem Programmier-Modus auf die gleiche Art wie die Programmierung der Bits des Kalibrationswertes N_{K} und des Bits DPW. Wenn das im Speicher 11 gespeicherte Bit UPI einen Logikwert "1" besitzt, dann sind die Signale TM 13 und TM 14 gleich Eins. Die Signale TM1 und TM3 besitzen beide je einen Logikwert Null.

Das Signal TM3B ist gleich Eins und das Signal TM13B gleich Null. Der letztere Wert veranlasst, dass die beiden Und-Gatter 78 und 112 gesperrt sind (siehe Fig. 10), was dazu führt dass der digitale Hardware-Quantisierer 10 und der Impulsgenerator 73 ausser Betrieb sind. Dies hat zur Folge, dass die Werte des in den Speicher 11 gespeicherten Kalibrationswertes N_{K} und des Bits DPW bedeutungslos sind. In der abgewandelten zweiten Variante können somit die Ausgangsimpulse der erfindungsgemässen Anordnung nicht innerhalb der letzteren, sondern müssen im externen Computer 17 kalibriert werden. Der letztere ist in der abgewandelten zweiten Variante dauernd mindestens über die vier Leiter 18 bis 21 mit der erfindungsgemässen Anordnung verbunden. Das Signal MOSI ist, nachdem das Bit UPI bereits vorher im Programmier-Modus gespeichert wurde, dauernd Null, so dass keine von Null unterschiedliche Bitwerte in das Schieberegister 62 geschoben und demnach keine solche Werte in den Hilfsspeicher 72 und/oder den Speicher 11 geladen werden können. Ausserdem legt das Signal TM13 über das Nor-Gatter 83 einen Logikwert "0" an den Programmier-Eingang 64b, so dass alle Freigabe-Gatter 64a gesperrt sind, was zusätzlich eine Umprogrammierung des Speichers 11 verhindert. Da das Signal TM13 Eins ist, steht ein Logikwert "0" am Ausgang des Nor-Gatters 76 an, welcher verhindert, dass der Umschalter 77 umgeschaltet wird. Die Impulse am seriellen Ausgang 14a des Serie/Parallel-Wandlers 14 erreichen zeitseriell über das durch das Signal TM 14 freigegebene Und-Gatter 71 und den nichtumgeschaltenen Umschalter 77 den Ausgang OUT der erfindungsgemässen Anordnung, der über einen weiteren Leiter mit einem Eingang des Computers 17 verbunden ist. Mit anderen Worten: Die Bauelemente 1, 8, 9, 14, 60, 61, 68, 69, 70, 71, 76, 77, 79, 80, 81, 84, 85, 86, 87, 88, 93, 95, 96, 97, 102, 103, 104, 105 und 110 werden benötigt und Bitwerte, die die ermittelte Leistung darstellen und im Serie/Parallel-Wandler 14 zwischengespeichert sind, werden zeitseriell vom Ausgang 14a zu einem Eingang des Computers 17 übertragen. Wenn der Computer 17 keinen Logikwert "1" an den Leiter 21 legt, bedeutet dies, dass er jeden Logikwert "1", der dort seitens der erfindungsgemässen Anordnung mittels des D-Flip Flops 97 angelegt wird, als Signal RDY interpretiert, mit dem die erfindungsgemässe Anordnung ihm mitteilt, dass sie betriebsbereit ist. Die Signale CE3 und CLE besitzen je eine Frequenz von 4 Hz. Das letztere Signal ist leicht gegenüber dem ersteren zeitverzögert. Die steigenden Flanken des Signals CLE invertiert, d. h. des Signals CLEB, laden alle 250ms einen Logikwert "1" in das D-Flip Flop 97, da das Signal TM14 gleich Eins ist. Das Q-Ausgangssignal des D-Flip Flops 97 erreicht über den Leiter 21 als Signal RDY den Computer 17, der dadurch die Betriebsbereitschaft erkennt und dies durch ein Umschalten des Signals ENI von einem Logikwert "0" auf einen Logikwert "1" bestätigt. Gleichzeitig schaltet er die Taktimpulse des Signals SCK auf den Leiter 20. Der Logikwert "1" des Signals ENI stellt jeweils über die Gatter 93, 95 und 96 das D-Flip Flop 97 auf Null zurück, wodurch das Signal RDY auch auf Null geht. Es besteht somit aus eine Impulsreihe der Frequenz 4 Hz. Um eine Zeitdauer Δt3 leicht verzögert erscheint ein Logikwert "1" am Ausgang des Zeitverzögerungsgliedes 105, der über das Oder-Gatter 79 das Und-Gatter 80 freigibt, so dass das Taktsignal SCK den Takteingang des Serie/Parallel-Wandlers 14 erreicht. Zu diesem Zweck stellt das Signal ENI über den Inverter 102 und das Oder-Gatter 104 das Zeitverzögerungsglied 110 auf Null zurück, wodurch der Umschalter 81 umgeschaltet und das Taktsignal SCK auf das Und-Gatter 80 geschaltet wird. Das Taktsignal SCK schiebt die im Serie/Parallel-Wandler 14 gespeicherten Bits zeitseriell aus dem letzteren heraus und hin zum Ausgang OUT der erfindungsgemässen Anordnung. Nachdem alle Bits hinausgeschoben sind, z. B. nach 240ms, schaltet der Computer 17 das Signal SCK auf den Dauer-Logikwert "1"und das Signal ENI auf den Logikwert Null. Durch das auf Nullschalten des Signals ENI wird das Zeitverzögerungsglied 105 über den Inverter 102 und das Nor-Gatter 103 auf Null zurückgestellt, so dass das Signal CE3 über das Oder-Gatter 79 das Und-Gatter 80 erreicht. Gleichzeitig gibt das Signal ENI über den Inverter 102 und das Oder-Gatter 104 das Zeitverzögerungsglied 110 wieder frei, so dass das Taktsignal CLK den Logikwert "1"' laden kann, der invertiert und um die Dauer Δt2 verzögert den QB-Ausgang des Zeitverzögerungsgliedes 110 erreicht. Dadurch wird der Umschalter 81 zurückgeschaltet, so dass das Taktsignal CLK das Und-Gatter 80 erreicht, um während der Dauer der Impulse des 4Hz-Signals CE3 den Takteingang des Serie/Parallel-Wandlers 14 zu speisen. Dies hat zur Folge, dass während dieser Zeit die die ermittelten Leistungswerte darstellenden Bitwerte zeitseriell aus dem Digitalfilter 9 heraus in den Serie/Parallel-Wandler 14 hineingeschoben werden. Zusammengefasst: Während des Normalbetriebs der abgewandelten zweiten Variante ist im unverlierbaren Speicher 11 ein bestimmter vorgegebener Bitwert, nämlich der Logikwert "1" des Bits UPI gespeichert. Im Betrieb ist zeitlich abwechselnd das interne Taktsignal CLK oder das vom Computer 17 gesandte Schnittstellen-Taksignal SCK auf den Takteingang des Serie/Parallel-Wandlers 14 geführt zwecks einem jeweils zeitseriellen Hineinschieben eines digitalen Leistungswertes aus dem Analog/Digital-Wandler 2 in den Serie/Parallel-Wandler 14 beziehungsweise des dort gespeicherten digitalen Leistungswertes aus dem Serie/Parallel-Wandler 14 in den Computer 17. Nach dem Hineinschieben in den Serie/Parallel-Wandler 14 ist jeweils ein zum Computer 17 gesandtes Betriebsbereit-Signal RDY vorhanden, welches zeitlich gefolgt ist von zwei seitens des Computers 17 zeitweise über getrennte Leiter 20 und 19 gesandten Signalen SCK und ENI. Ein Empfang des letzteren in der erfindungsgemässen Anordnung hat eine Beendigung des Betriebsbereit-Signals RDY sowie ein Umschalten des Takteingangs des Serie/Parallel-Wandlers 14 vom internen Taktsignal CLK auf das Schnittstellen-Taktsignal SCK zur Folge.

Während des Test-Modus der abgewandelten zweiten Variante ist der Computer 17 über die Leiter 18 bis 21 mit der erfindungsgemässen Anordnung verbunden und der Ausgang OUT der letzteren über einen weiteren Leiter auf einen Eingang des ersteren geführt. Zu Beginn ist das Signal ENI gleich Null, so dass die Bauelemente 62, 67, 72, 84, 86, 94 und 106 auf Null zurückgestellt sind. Das Signal SCK besitzt zu diesem Zeitpunkt einen Dauer-Logikwert "1". Zu Beginn des Test-Modus muss ein Logikwert "1" des Bits TUPI in den Hilfsspeicher 72 gespeichert werden, indem der Computer 17 das Signal ENI auf Logikwert "1" schaltet und gleichzeitig die Übertragung des Signals MOSI und der Taktimpulse des Signals SCK beginnt. Das dritte Bit TUPI des Signals MOSI besitzt den Logikwert "1". Nachdem das Signal MOSI in das Schieberegister 62 hineingeschoben ist, lädt der am Q-Ausgang des D-Flip Flops 86 erscheinende Logikwert "1" den Logikwert "1" des Bits TUPI aus dem Schieberegister 62 in die zugehörige Speicherzelle des Hilfsspeichers 72. Dadurch nehmen die Signale TM3 und TM14 einen Logikwert "1" und das Signal TM3B einen Logikwert "0" an. Die Signale TM13 und TM13B behalten dagegen ihren Logikwert "0" bzw. "1". Im Gegensatz zum Programmier-Modus der zweiten Variante wird zwar mit der 32-ten fallenden Flanke des Taktsignals SCK einen Logikwert "1" in das D-Flip Flop 86 geladen, jedoch schaltet der Computer 17 anschliessend nach der 32-ten steigenden Flanke das Taktsignal SCK aufden Dauer-Logikwert "1" um. Der Zähler 84 wird durch das QB-Ausgangssignal des D-Flip Flops 86 auf Null zurückgestellt, jedoch der dann an seinem Q-Ausgang erscheinende Logikwert "0" wird noch nicht in das D-Flip Flop 86 geladen. Der letztere behält somit vorläufig noch seinen Logikwert '"1", statt die fallende Flanke eines Impulses zu erzeugen. Das Erscheinen des Logikwertes "1" des Signals TM3 erzeugt an den Ausgängen der Gatter 111 und 112 einen Logikwert "0", der das Digitalfilter 9, den Serie/Parallel-Wandler 14, die Anordnung 10 und den Impulsgenerator 73 auf Null zurückgestellt. Mit der 32-ten steigenden Flanke des Taktsignals SCK wird anschliessend das D-Flip Flop 106 gesetzt, wodurch ein Logikwert "1" am Ausgang der Gatter 111 und 112 erscheint, welcher die Rückstellung der Bauelemente 9, 10, 14 und 73 aufhebt, so dass diese wieder Aufnahmebereit und in Betrieb sind. Der Logikwert "1"' am Q-Ausgang des D-Flip Flops 86 sperrt über den Inverter 90 das Und-Gatter 91. Die Ausgänge der Gatter 109 und 104 besitzen dann einen Logikwert "1", der die Rückstellung des Zeitverzögerungsgliedes 110 aufhebt, so dass dort, um die Zeitdauer Δt2 leicht verzögert, durch das Taktsignal CLK ein Logikwert "1" geladen wird, wodurch der QB-Ausgang des Zeitverzögerungsgliedes 110 einen Logikwert "0" annimmt. Der Umschalter 81 schaltet zurück, so dass das Taktsignal CLK das Und-Gatter 80 erreicht. Der Logikwert "1" des Signals TM3 erreicht über das freigegebene Und-Gatter 89 das Nor-Gatter 103, welches ein Logikwert "0" an den Rückstelleingang des Zeitverzögerungsgliedes 105 legt, wodurch dieses auf Null zurückgestellt und ein Logikwert "0" an einem der Eingänge des Oder-Gatters 79 gelegt wird. Dadurch wird das 4Hz-Signal CE3 am anderen Eingang des letzteren aktiv und schaltet während der Dauer seiner Impulse das Taktsignal CLK auf den Takteingang des Serie/Parallel-Wandlers 14. Dies hat zur Folge, dass die Leistungswert-Bits mittels des Taktsignals CLK zeitseriell aus dem Digitalfilter 9 in den Serie/Parallel-Wandler 14 geschoben werden. Der Logikwert "1" am Q-Ausgang des D-Flip Flops 86 sperrt über den Inverter 90 ausserdem auch das Und-Gatter 92 und, da das Und-Gatter 93 wegen TM13 ebenfalls gesperrt ist, erscheint am Ausgang des Nor-Gatters 96 während der Impulslücken des 4Hz-Signals CE3 ein Logikwert "1", der die Rückstellung des D-Flip Flops 97 aufhebt, so dass, da das Signal TM14 einen Logikwert "1" besitzt, die nachfolgende positive Flanke des 4Hz-Signals CLEB einen Logikwert "1"' in das D-Flip Flop 97 lädt und damit, als Signal RDY, auf den mit dem Computer 17 verbundenen Leiter 21 schaltet. Der Computer 17 erkennt dadurch die Betriebsbereitschaft der erfindungsgemässen Anordnung und bestätigt dies, indem er die Taktimpulse des Taktsignals SCK wieder zur erfindungsgemässen Anordnung überträgt. Die 1-te fallende Flanke des Taktsignals SCK lädt dann den am Q-Ausgang des Zählers 84 anstehende Logikwert "0" in das D-Flip Flop 86, wodurch ein Logikwert "1" am Ausgang der Gatter 92 und 95 erscheint, welcher den Ausgang des Nor-Gatters 96 auf Logikwert "0" schaltet, der dann das D-Flip Flop 97 und damit das Signal RDY auf Null zurückstellt. Ausserdem erscheint am Ausgang des Und-Gatters 91 ein Logikwert "1", der über die Gatter 109 und 104 das Zeitverzögerungsglied 110 auf Null zurückstellt, so dass dessen QB-Ausgang ein Logikwert "1" annimmt, welcher den Umschalter 81 umschaltet, so dass das Taktsignal SCK das Und-Gatter 80 erreicht.

Zusätzlich ist das Und-Gatter 89 jetzt gesperrt, so dass am Rückstelleingang des Zeiverzögerungsgliedes 105 ein Logikwert "1" ansteht, welcher dasselbe freigibt, so dass um eine Zeitdauer Δt3 leicht verzögert ein Logikwert "1" am Ausgang des Zeitverzögerungsgliedes 105 erscheint, welcher über das Oder-Gatter 79 das Und-Gatter 80 freigibt, so dass das Taktsignal SCK den Takteingang des Serie/Parallel-Wandlers 14 erreicht. Das Taktsignal SCK schiebt dann zum ersten Mal während des Test-Modus die im Serie/Parallel-Wandler 14 gespeicherten Leistungswert-Bits zeitseriell aus dem letzteren heraus zum Ausgang OUT der erfindungsgemässen Anordnung und damit zum Eingang des Computers 17, da wegen des Logikwertes "1" des Signals ENI ein Logikwert "0" am Ausgang des Nor-Gatters 76 ansteht, welcher verhindert, dass der Umschalter 77 umgeschaltet wird, und da ausserdem wegen des Logikwertes "1" des Signals TM 14 das Und-Gatter 71 freigegeben ist. Mit anderen Worten: Die Bauelemente 1, 8, 9, 14, 60, 61, 69, 71, 76, 77, 79, 80, 81, 84 bis 97, 102 bis 105 und 110 werden benötigt. Im Test-Modus können somit die Ausgsimpulse der erfindungsgemässen Anordnung nicht innerhalb der letzteren kalibriert werden, sondern die Kalibration muss im Computer 17 erfolgen. Nachdem, z. B. nach 240 ms, alle Leistungswert-Bits hinausgeschoben sind, schaltet der Computer 17 bei der 32-ten steigenden Flanke das Taktsignal SCK wieder auf den Dauer-Logikwert "1" und geht in Warteposition, bis dass die nächste steigende Flanke des 4Hz-Signals CLEB wieder mittels des D-Flip Flops 97 einen Logikwert "1" des Signals RDY erzeugt, worauf sich der beschriebene Zyklus wiederholt. Am Ende des letzteren werden die Leistungswert-Bits erneut, diesmal zum zweiten Mal, zeitseriell aus dem Serie/Parallel-Wandler 14 zum Ausgang OUT und damit zum Eingang des Computers 17 geschoben. Dieser Zyklus wiederholt sich anschliessend immer wieder, bis dass, um den Test-Modus zu beenden, der Computer 17 das Signal ENI auf Null schaltet, wodurch das Schieberegister 62, der Zähler 84 und die D-Flip Flops 67, 86, 94 und 106 auf Null zurückgestellt werden. Ausserdem lädt das im Inverter 102 invertierte Signal ENI Nullwerte aus dem Schieberegister 62 in den Hilfsspeicher 72, wodurch der letztere und die Signale TM3 und TM14 auf Null zurückgestellt werden, was den Test-Modus deaktiviert. Zusammengefasst: Im Betrieb des Test-Modus der abgewandelten zweiten Variante ist nach der Speicherung eines bestimmten vorgegebenen vom Computer 17 ausgesandten Bitwertes, nämlich des Logikwertes "1" des Bits TUPI, zeitlich abwechselnd das interne Taktsignal CLK oder ein vom Computer 17 gesandtes Schnittstellen-Taksignal SCK auf einen Takteingang des Serie/Parallel-Wandlers 14 geführt zwecks einem jeweils zeitseriellen Hineinschieben eines digitalen Leistungswertes aus dem Analog/Digital-Wandler 2 in den Serie/Parallel-Wandler 14 beziehungsweise des dort gespeicherten digitalen Leistungswertes aus dem Serie/Parallel-Wandler 14 in den Computer 17. Nach dem Hineinschieben in den Serie/Parallel-Wandler 14 ist jeweils ein zum Computer 17 gesandtes Betriebsbereit-Signal RDY vorhanden, welches zeitlich gefolgt ist von dem seitens des Computers 17 zeitweise über den getrennten Leiter 20 gesandten Schnittstellen-Taktsignal SCK. Ein Empfang des letzteren in der erfindungsgemässen Anordnung hat eine Beendigung des Betriebsbereit-Signals RDY und ein Umschalten des Takteingangs des Serie/Parallel-Wandlers 14 vom internen Taktsignal CLK auf das Schnittstellen-Taktsignal SCK zur Folge.

In einem Kontroll-Modus kann vor einem Programmier-Modus getestet werden, ob ein vom Computer 17 berechneter Kalibrationswert N_{K} korrekt ist. Zu diesem Zweck wird der letztere als Teil des Signals MOSI vom Computer 17 über die Kommunikations-Schnittstelle 16 der Anordnung zugeführt. Das neunte Bit TPRE des Signals MOSI besitzt einen Logikwert "1", während die Bits TPRG, TRFP und BTF je einen Logikwert Null aufweisen. Vor dem Kontroll-Modus besitzt das Signal ENI einen Logikwert "0", welcher die Bauelemente 62, 72, 84, 86 und 210 auf Null zurückgestellt. Die Ausgangssignale TM1, TM2 und TM9 des Hilfsspeichers sind somit alle drei Null. Zu Beginn des Kontroll-Modus setzt der Computer 17 das Signal ENI auf Logikwert "1", wodurch die Bauelemente 62, 86 und 210 freigegegeben werden und der Zählvorgang des Zählers 84 gestartet wird. Das Taktsignal SCK schiebt anschliessend das Signal MOSI in das Schieberegister 62, wo seine Bits gespeichert werden. Wenn das Signal MOSI in das Schieberegister 62 hineingeschoben ist, veranlasst der am Q-Ausgang des D-Flip Flops 86 erscheinende Impuls, dass der im Schieberegister 62 gespeicherte Kalibrationswert N_{K} in den Hilfsspeicher 203 und die im Schieberegister 62 gespeicherten Werte der Bits TPRG, TRFP und TPRE in die ihnen zugehörigen Speicherzellen des Hilfsspeichers 72 gespeichert werden (siehe Fig. 11). Da die Bits TPRG und TRFP je einen Logikwert "0" besitzen, behalten die Signale TM 1 und TM2 ihren Logikwert "0", während das Signal TM9 einen Logikwert "1" annimmt, welcher den Mehrbit-Umschalter 204 umschaltet, so dass der im Hilfsspeicher 203 gespeicherte Kalibrationswert N_{K} über die Busverbindung 205, den umgeschalteten Mehrbit-Umschalter 204 und die Busverbindung 206 den Buseingang 10a des Quantisierers 10 erreicht, dessen Ausgangsimpulse somit mit diesem Kalibrationswert N_{K} bzw. der zugehörigen Kalibrationskonstante N'_{K} gewichtet werden, bevor sie zu Kontrollzwecken über den vom Signal TM9 über das Oder-Gatter 214 umgeschalteten Umschalter 77 und den Ausgang OUT der Anordnung dem Computer 17 zugeführt werden. Dieser kann somit eine erneute Messung veranlassen, um festzustellen, ob der verwendete Kalibrationswert N_{K} korrekt ist, und wenn nicht, diesen korrigieren. Im letzteren Fall kann er dann den beschriebenen Kontroll-Modus mit korrigiertem Kalibrationswert N_{K} wiederholen, um festzustellen, ob dieser nun korrekt ist. Am Endes eines jeden Kontroll-Modus veranlasst der Computer 17 wieder eine allgemeine Rückstellung, indem er das Signal ENI auf Null schaltet, wodurch unter anderem der Inhalt des Hilfsspeichers 203 gelöscht wird. Der berechnete und möglicherweise korrigierte Kalibrationswert N_{K} ist somit nur provisorisch und nur zu Kontrollzwecken im Hilfsspeicher 203 gespeichert und kann zu diesem Zeitpunkt jederzeit noch geändert werden.

Am Ende des Programmier-Modus, wenn alle Logikwerte "1" des Kalibrationswertes N_{K} im Speicher 11 gespeichert sind, gibt es eine letzte Möglichkeit, die Richtigkeit des dort abgespeicherten Kalibrationswertes N_{K} in einem Lese-Modus zu kontrollieren und anschliessend in mindestens einem weiteren Programmierzyklus gegebenenfalls zu korrigieren durch Hinzufügen fehlender Bitwerte "1". Löschen von falschen Bitwerte "1" ist nicht möglich, da die zugehörigen Dioden bzw. Zenerdioden zerstört sind. Im Lese-Modus sind die zehn letzten, zum Kalibrationswert N_{K} gehörenden Bits sowie die Bits TPRG, TPRE und BTF des vom Computer 17 gesandten Signals MOSI alle gleich Null, während dessen zweites Bit TRFP einen Logikwert "1" aufweist. Vor dem Lese-Modus besitzt das Signal ENI wieder einen Logikwert "0". Die Bauelemente 62, 72, 84, 86, 203 und 210 sind dementsprechend auf Null zurückgestellt und die Signale TM1, TM2 und TM9 gleich Null. Zu Beginn des Lese-Modus setzt der Computer 17 das Signal ENI auf Logikwert "1", wodurch die erwähnten auf Null zurückgestellten Bauelemente freigegegeben werden und der Zählvorgang des Zählers 84 gestartet wird. Wenn das Signal MOSI in das Schieberegister 62 hineingeschoben ist, lädt der am Q-Ausgang des D-Flip Flops 86 erscheinende Impuls die im Schieberegister 62 gespeicherten Bits TPRG, TRFP und TPRE in die ihnen zugehörigen Speicherzellen des Hilfsspeichers 72. Die Signale TM 1 und TM9 behalten jeweils ihren Logikwert "0", da die Werte der Bits TPRG und TPRE Null sind. Der Umschalter 77 schaltet nicht um, da das Oder-Gatter 214 ein Ausgangssignal Null aufweist. Somit ist nicht der Ausgang des Impulsgenerators 73, sondern der Q-Ausgang des D-Flip Flops 210 mit dem Ausgang OUT der Anordnung verbunden. Da das Lese-Bit TRFP einen Logikwert "1" besitzt, nimmt das Signal TM2 einen Logikwert "1" an, welcher die Nand-Gatter 202 und 211 sowie das Und-Gatter 212 freigibt. Am Ausgang des Nand-Gatters 211 erscheint ein negativgehender Impuls, der veranlasst, dass der im Speicher 11 gespeicherte Kalibrationswert N_{K} parallel in den zehn letzten, in der Fig. 11 linken Speicherzellen des Schieberegisters 62 zurückgeladen wird. Die nächsten Taktimpulse des Schnittstellen-Taktsignals SCK schieben dann den Inhalt des Schieberegisters 62 über dessen Serieausgang hinaus, so dass er über das D-Flip Flop 210 und den Ausgang OUT der Anordnung den Computer 17 erreicht, wo er zu Kontrollzwecken verwendet werden kann, z. B. zwecks Ermittlung von Korrekturwerten des im Speicher 11 gespeicherten Kalibrationswertes N_{K}. Der Computer 17 beendet den Lese-Modus, indem er das Signal ENI auf Null zurückschaltet, wodurch die Anordnung auf Null zurückgestellt wird.

Wenn nach dem Programmier- und gegebenenfalls Lese-Modus der im Speicher 11 gespeicherte Kalibrationswert N_{K} als korrekt empfunden wird, muss er unwiderruflich definitif gemacht werden, damit er später absichtlich oder unabsichtlich nicht mehr geändert werden kann. Zu diesem Zweck wird in einem Programmier-Abschlussmodus ein einzelner Programmierzyklus durchgeführt, um ein Logikwert "1" des Sperr-Bits BTF in den Speicher 11 zu speichern. Falls das Sperr-Bit BTF in einem Programmier-Abschlussmodus bereits vor dem Lese-Modus auf Logikwert "1" programmiert wurde, kann der Lese-Modus verwendet werden zur Kontrolle, ob die betreffende Anordnung bereits definitif kalibriert ist oder nicht. Im Programmier-Abschlussmodus werden, nachdem der Kalibrationswert N_{K} beziehungsweise alle Pseudo-Kalibrationswerte im Speicher 11 gespeichert sind, das Signal MOSI, das Schnittstellen-Taktsignal SCK, das Schnittstellen-Freigabesignal ENI sowie der Programmierimpuls PRG vom Computer 17 über die Kommunikations-Schnittstelle 16 der Anordnung zugeführt. Im Programmier-Abschlussmodus besitzen die zehn letzten, zum Kalibrationswert N_{K} gehörenden Bits sowie die Bits TRFP und TPRE des vom Computer 17 gesandten Signals MOSI je einen Logikwert "0", während die Bits TPRG und BTF je einen Logikwert "1" aufweisen. Vor dem Programmier-Abschlussmodus, besitzt das Signal ENI einen Logikwert "0" und sind die Bauelemente 62, 72, 84, 86, 203 und 210 auf Null zurückgestellt. Die Signale TM1, TM2 und TM9 sind somit alle drei Null. Zu Beginn des Programmier-Abschlussmodus setzt der Computer 17 das Signal ENI auf Logikwert "1", wodurch die auf Null zurückgestellen Bauelemente freigegeben werden und der Zählvorgang des Zählers 84 gestartet wird.

Wenn das Signal MOSI in das Schieberegister 62 hineingeschoben ist, erscheint der Impuls am Q-Ausgang des D-Flip Flops 86, welcher über das Oder-Gatter 101 veranlasst, dass die im Schieberegister 62 gespeicherten Bits TPRG, TRFP und TPRE in die ihnen zugehörigen Speicherzellen des Hilfsspeichers 72 gespeichert werden. Da das Zusatz-Bit TPRG einen Logikwert "1"' besitzt, nimmt das Signal TM1 einen Logikwert "1" an, welcher das Und-Gatter 207 freigibt (siehe Fig. 11). Die Signale TM2 und TM9 behalten jeweils ihren Logikwert "0", da die Werte der Bits TRFP und TPRE Null sind. Ein anschliessend vom Computer 17 über den Leiter 21 gesandter kurzer Programmierimpuls PRG, z. B. der Dauer 10µs, erreicht über die freigegebenen Gatter 207und 208 den Programmier-Eingang 64b der Programmier-Freigabeanordnung 64, wodurch unter anderem dessen zum Sperr-Bit BTF gehörendes Freigabe-Gatter 64a für die Dauer des Programmierimpulses freigegeben wird. Dadurch wird die zum Sperr-Bit BTF gehörende Speicherzelle des Speichers 11 programmiert und dort ein Logikwert "1" gespeichert bzw. eingebrannt. Das Sperr-Bit BTF wird somit mit Hilfe des im Hilfsspeicher 72 gespeicherten Bits TPRG und des Programmierimpulses PRG in den Speicher 11 gespeichert. Das im Speicher 11 gespeicherte Sperr-Bit BTF wird schliesslich verwendet, um definitif ein weiteres Laden des Speichers 11 zu verhindern, indem sein Logikwert "1" über den Inverter 209 das Sperr-Gatter 208 für immer sperrt. Dadurch kann in Zukunft definitif kein Programmierimpuls PRG mehr den Programmier-Eingang 64b erreichen und kann somit der Inhalt des Speichers 11 nicht mehr geändert werden. Der Computer 17 beendet den Programmier-Abschlussmodus, indem er das Signal ENI auf Null zurücksetzt, wodurch die Anordnung auf Null zurückgestellt wird. Wenn die Anordnung definitif kalibriert ist, d. h. wenn alle deren in ihrem Speicher 11 gespeicherten Sperr-Bits BTF je einen Bitwert "1" besitzen, kann die zu kalibrierende Anordnung aus der Kalibrations-Einrichtung entfernt und kalibriert z. B. auf Lager gelegt werden.

Ein Teil des Speichers 11 kann zusätzlich zum Speichern weiterer Informationen verwendet werden. Dies sind z. B. digital einstellbare oder steuerbare Parameter, wie Temperaturkoeffizient-Kompensationswerte und/oder Offsetspannungs-Abgleichswerte, letztere z. B. zur Berücksichtigung einer Lastkurve. Es können aber auch Herstellungsangaben sein, wie z. B ein Produktionskode, ein Herstellungsdatum und/oder eine Herstellungsnummer. Diese Informationen können, jede für sich oder zusammen miteinander, allein oder zusätzlich zum Kalibrationswert N_{K} bzw. zum Pseudo-Kalibrationswert und den Bits TPRG, TRFP, TUPI, TPRE, BTF, UPI und DPW als Signal MOSI vom Computer 17 über die Kommunikations-Schnittstelle 16 zur Anordnung übertragen und dort im Speicher 11 gespeichert werden.

## Patentansprüche

1. Anordnung zum Messen elektrischer Energie mit mindestens einem Messystem und pro Messystem mit
- einer Anordnung (1) zur Ermittlung analoger Leistungswerte (p[t]) und
- einem der Anordnung (1) zur Ermittlung analoger Leistungswerte (p[t]) nachgeschalteten Analog/Digital-Wandler (2),
- wobei dem Analog/Digital-Wandler (2) eine Anordnung (10) zur digitalen Quantisierung nachgeschaltet ist,
**dadurch gekennzeichnet, dass**
der Analog/Digital-Wandler (2) jeweils einen Sigma-Delta-Modulator (8) sowie ein dem letzteren nachgeschaltetes Digitalfilter (9) enthält und
dass ein Polwender (3) in der Anordnung (1) zur Ermittlung analoger Leistungswerte (p[t]) und ein Polwender im Sigma-Delta-Modulator (8) vorhanden ist, deren Umschaltfrequenz (2⁵ Hz) ein ganzzahliges Vielfaches einer Abtastfrequenz (4 Hz) des Digitalfilters (9) ist, wobei der Polwender in der Anordnung (1) die analogen Leistungswerte (p[t]) ein erstes Mal periodisch umschaltet und der Polwender des Sigma-Delta-Modulators (8) die Leistungswerte (p[t]) ein zweites Mal periodisch umschaltet und zudem eine ausgangsseitig der Anordnung (1) vorliegende Offset-Spannung einmalig periodisch umschaltet, so dass eine nachfolgende Mittelwertbildung der Halbwellen im Digitalfilter (9) diese Offset-Spannung der Anlage (1) eliminiert und lediglich die analogen Leistungswerte (p[t]) Berücksichtigung finden.

2. Anordnung nach Anspruch 1, **dadurch gekennzeichnet, dass** die Quantisierung mittels eines in einem unverlierbaren Speicher (11) gespeicherten Kalibrationswertes (N_{K}) steuerbar ist.

3. Anordnung nach Anspruch 2, **dadurch gekennzeichnet, dass** der Kalibrationswert (N_{K}) ein variabler Anteil einer Kalibrationskonstante (N'_{K}) ist.

4. Anordnung nach Anspruch 2 oder 3, **dadurch gekennzeichnet, dass** der unverlierbare Speicher (11) ein feldprogrammierbarer oder ein elektrisch programmierbarer Festwertspeicher (FPROM bzw. EEPROM) ist, dessen Busausgang (11a) mit einem Buseingang (10a) der Anordnung (10) zur digitalen Quantisierung verbunden ist.

5. Anordnung nach einem der Ansprüche 2 bis 4, **dadurch gekennzeichnet, dass** die Anordnung (10) zur digitalen Quantisierung ein Computer (12) ist, der mit einer die digitale Quantisierung durchführenden Software versehen ist, und der unverlierbare Speicher (11) ein Teil der Computerspeicher ist.

6. Anordnung nach Anspruch 5, **dadurch gekennzeichnet, dass** als Anordnung (10) zur digitalen Quantisierung ein einziger für alle Messysteme gemeinsamer Computer (12) vorhanden ist.

7. Anordnung nach Anspruch 5 oder 6, **dadurch gekennzeichnet, dass** ein Ausgang des Analog/Digital-Wandlers (2) jeweils über eine serielle Schnittstelle (13) mit dem Computer (12) verbunden ist.

8. Anordnung nach Anspruch 5 oder 6, **dadurch gekennzeichnet, dass** ein Ausgang des Analog/Digital-Wandlers (2) jeweils über einen Serie/Parallel-Wandler (14) und eine an dessen seriellen Ausgang (14a) angeschlossene Kommunikations-Schnittstelle (16) mit dem Computer (12, 17) verbunden ist.

9. Anordnung nach einem der Ansprüche 2 bis 4, **dadurch gekennzeichnet, dass** die Anordnung (10) zur digitalen Quantisierung ein digitaler Hardware-Quantisierer ist.

10. Anordnung nach Anspruch 9, **dadurch gekennzeichnet, dass** ein serieller Ausgang des Analog/Digital-Wandlers (2) auf einen seriellen Eingang (IN) eines Serie/Parallel-Wandlers (14) geführt ist, dessen Parallel-Ausgang mit einem Buseingang (10b) des digitalen Hardware-Quantisierers verbunden ist.

11. Anordnung nach Anspruch 9 oder 10, **dadurch gekennzeichnet, dass** im digitalen Hardware-Quantisierer
- ein Buseingang eines ersten Zwischenspeichers (24) den Buseingang (10b) des digitalen Hardware-Quantisierers bildet,
- ein von einem ersten Taktsignal (CL2) gesteuerter Mehrbit-Umschalter (25) vorhanden ist zur periodisch abwechselnden Verbindung eines ersten Buseingangs (B) eines algebraischen Addierers (26) mit einem Busausgang (24a bzw. 23a) des ersten Zwischenspeichers (24) beziehungsweise einer Biterweiteung-Schaltung (23), wobei an einem Buseingang (23b) der letzteren der im unverlierbaren Speicher (11) gespeicherte Kalibrationswert (N_{K}) ansteht,
- ein Busausgang (S) des algebraischen Addierers (26) mit einem Buseingang eines zweiten Zwischenspeichers (27) verbunden ist, dessen Busausgang auf einen zweiten Buseingang (A) des algebraischen Addierers (26) geführt ist,
- dass ein Freigabe-Gatter (30) vorhanden ist zum Laden, wenn der erste Buseingang (B) des algebraischen Addierers (26) mit dem Busausgang (24a) des ersten Zwischenspeichers (24) verbunden ist, des Ausgangswertes des algebraischen Addierers (26) in den zweiten Zwischenspeicher (27) mittels eines zweiten Taktsignals (CL4),
- dass in der Zeit, während der der erste Buseingang (B) des algebraischen Addierers (26) mit dem Busausgang (23a) der Biterweiterung-Schaltung (23) verbunden ist, bei einem im ersten Zwischenspeicher (24) gespeicherten negativen Wert (POUT) der algebraische Addierer (26) ein Additionsglied und bei einem im ersten Zwischenspeicher (24) gespeicherten positiven Wert (POUT) ein Subtraktionsglied ist, dessen Ausgangswert im letzteren Fall gleich der Differenz (X-N'_{K}) zwischen einem gerade im zweiten Zwischenspeicher (27) gespeicherten Wert (X) und dem am Busausgang (23a) der Biterweiterung-Schaltung (23) anstehenden Wert einer Kalibrationskonstante (N'_{K}) ist,
- dass diejenigen Ausgänge der Busausgänge (24a, S) des ersten Zwischenspeichers (24) und des algebraischen Addieres (26), an denen jeweils das höchstwertigste Bit (MSB1 bzw. MSB2) ansteht, mit je einem Eingang eines nachgeschalteten Impulsgenerators (41) verbunden sind zwecks jeweiliger Erzeugung eines Impulses am Ausgang des Impulsgenerators (41), wenn zur Zeit, während der der erste Buseingang (B) des algebraischen Addierers (26) mit dem Busausgang (23a) der Biterweiterung-Schaltung (23) verbunden ist, beide höchstwertigste Bits (MSB1, MSB2) identisch sind, und
- dass der Ausgang des Impulsgenerators (41) mit einem Lade-Eingang (27a) des zweiten Zwischenspeichers (27) verbunden ist.

12. Anordnung nach einem der Ansprüche 1 bis 11, **dadurch gekennzeichnet, dass** das Digitalfilter (9) mindestens eine Filterstufe enthält, deren Übertragungsfunktion mindestens zweiter Ordnung ist (Sinc^{K} mit K≥2).

13. Anordnung nach Anspruch 12, **dadurch gekennzeichnet, dass** das Digitalfilter (9) eine Reihenschaltung eines ersten Sinc²-Filters (42) und eines nachgeschalteten zweiten Sinc²-Filters (43) enthält.

14. Anordnung nach Anspruch 13, **dadurch gekennzeichnet, dass** das erste und das zweite Sinc²-Filter (42, 43) jeweils einen ersten digitalen Integrator (44 bzw. 57) und einen nachgeschalteten zweiten digitalen Integrator (45 bzw. 59) enthält, welcher letzterer eine Rückstellung besitzt, und dass nach dem zweiten digitalen Integrator (45 bzw. 59) eine Dezimation vorhanden ist, der jeweils ein digitales Differentiationsglied (54) nachgeschaltet ist.

15. Anordnung nach Anspruch 14, **dadurch gekennzeichnet, dass** das erste Sinc²-Filter (42) 12 Bits sowie einen Dezimationsfaktor-Wert 32 und dass das zweite Sinc²-Filter (43) 32 Bits sowie einen Dezimationsfaktor-Wert 1024 besitzt.

16. Anordnung nach einem der Ansprüche 2 bis 15, **dadurch gekennzeichnet, dass** der unverlierbare Speicher (11) von einem Computer (17) über eine serielle Kommunikations-Schnittstelle (16) programmierbar ist.

17. Anordnung nach Anspruch 16, **dadurch gekennzeichnet, dass** die serielle Kommunikations-Schnittstelle (16) Empfänger und Speicher für seitens des Computers (17) ausgesandte Bitwerte eines zum Kalibrationswert (N_{K}) in Beziehung stehenden Kodewortes (N_{K} bzw. Pseudo-Kalibrationswert) sowie zusätzlicher Bits (DPW, UPI, TUPI, TPRG, TRFP, TPRE, BTF) ist.

18. Anordnung nach Anspruch 16 oder 17, **dadurch gekennzeichnet, dass** zu den vom Computer (17) ausgesandten Bitwerten gehörende Bits die Gestalt eines über einen Leiter (18) einer Kommunikations-Schnittstellenbusverbindung (16b) übertragenen zeitseriellen Signals (MOSI) besitzen und dass in der Kommunikations-Schnittstellenbusverbindung (16b) mindestens drei weitere Leiter (19, 20, 21) vorhanden sind, über denen ein Schnittstellen-Taktsignal (SCK) beziehungsweise ein Schnittstellen-Freigabesignal (ENI) beziehungsweise ein Programmierimpuls (PRG) vom Computer (17) zur Anordnung übertragen wird, wobei der Programmierimpuls (PRG) dazu dient, mit Hilfe eines der empfangenen zusätzlichen Bits (TPRG) das mit dem Kalibrationswert (N_{K}) in Beziehung stehende Kodewort (N_{K} bzw. Pseudo-Kalibrationswert) in den unverlierbaren Speicher (11) zu speichern.

19. Anordnung nach einem der Ansprüche 16 bis 18, **dadurch gekennzeichnet, dass** die serielle Kommunikations-Schnittstelle (16) ein Schieberegister (62) zum zeitseriellen Speichern der vom Computer (17) ausgesandten Bitwerte (N_{K}, Pseudo-Kalibrationswerte, DPW, UPI, TUPI, TPRG, TRFP, TPRE, BTF) sowie eine Programmierungs-Freigabeanordnung (64) enthält zur Weiterleitung mindestens eines Teils der im Schieberegister (62) gespeicherten Bitwerte (N_{K}, Pseudo-Kalibrationswerte, DPW, UPI, BTF) an den unverlierbaren Speicher (11) zwecks dortiger Speicherung und dass ein Hilfsspeicher (72) vorhanden ist zur Speicherung eines weiteren Teils der im Schieberegister (62) gespeicherten Bitwerte (TUPI, TPRG, TRFP, TPRE).

20. Anordnung nach Anspruch 19, **dadurch gekennzeichnet, dass** der Ausgang des unverlierbaren Speichers (11) über eine Busverbindung (11b) mit einem Paralleleingang von zum Kalibrationswert (N_{K}) gehörenden Speicherzellen des Schieberegisters (62) verbunden ist zwecks Rückspeicherung des Inhaltes (N_{K}) des unverlierbaren Speichers (11) in das Schieberegister (62), dessen Inhalt dann zum Computer (17) übertragbar ist zwecks dortigem Lesen des Inhaltes (N_{K}) des unverlierbaren Speichers (11).

21. Anordnung nach Anspruch 19 oder 20, **dadurch gekennzeichnet, dass** die Programmierungs-Freigabeanordnung (64) ein Freigabe-Gatter (64a) für eine zugehörige Speicherzelle des unverlierbaren Speichers (11) enthält zwecks dortigem Speichern eines vom Computer (17) über die Kommunikations-Schnittstelle (16) übertragenen und im Schieberegister (62) zwischengespeicherten Sperr-Bits (BTF) und dass ein Ausgang der betreffenden Speicherzelle des unverlierbaren Speichers (11) mit einem Eingang eines Sperr-Gatters (208) verbunden ist zwecks Sperrung von anderen Freigabe-Gattern (64a) der Programmierungs-Freigabeanordnung (64).

22. Anordnung nach einem der Ansprüche 19 bis 21, **dadurch gekennzeichnet, dass** von zum Kalibrationswert (N_{K}) gehörenden Parallelausgängen des Schieberegisters (62) mit einem Buseingang eines weiteren Hilfsspeicher (203) verbunden sind und dass ein Mehrbit-Umschalter (204) vorhanden ist zwecks eines Umschaltens des Buseinganges (10a) der Anordnung (10) zur digitalen Quantisierung vom Busausgang (11a) des unverlierbaren Speichers (11) auf einen Busausgang des weiteren Hilfsspeichers (203).

23. Anordnung nach einem der Ansprüche 16 bis 22, **dadurch gekennzeichnet, dass** ein Ausgang des Analog/Digital-Wandlers (2) über einen Serie/Parallel-Wandler (14) mit einem Eingang des Computers (17) verbunden ist und im Betrieb, nach der Speicherung eines bestimmten vorgegebenen vom Computer (17) ausgesandten Bitwertes (TUPI), zeitlich abwechselnd ein internes Taktsignal (CLK) oder ein vom Computer (17) gesandtes Schnittstellen-Taksignal (SCK) auf einen Takteingang des Serie/Parallel-Wandlers (14) geführt ist zwecks einem jeweils zeitseriellen Hineinschieben eines digitalen Leistungswertes aus dem Analog/Digital-Wandler (2) in den Serie/Parallel-Wandler (14) beziehungsweise des dort gespeicherten digitalen Leistungswertes aus dem Serie/Parallel-Wandler (14) in den Computer (17).

24. Anordnung nach Anspruch 23, **dadurch gekennzeichnet, dass** nach dem Hineinschieben in den Serie/Parallel-Wandler (14) jeweils ein zum Computer (17) gesandtes Betriebsbereit-Signal (RDY) vorhanden ist, welches zeitlich gefolgt ist von einem seitens des Computers (17) zeitweise über einen getrennten Leiter (20) gesandten Schnittstellen-Taktsignal (SCK), und dass ein Empfang des letzteren eine Beendigung des Betriebsbereit-Signal (RDY) und ein Umschalten des Takteingangs des Serie/Parallel-Wandlers (14) vom internen Taktsignal (CLK) auf das Schnittstellen-Taktsignal (SCK) zur Folge hat.

25. Anordnung nach einem der Ansprüche 2 bis 24, **dadurch gekennzeichnet, dass** ein Ausgang des Analog/Digital-Wandlers (2) über einen Serie/Parallel-Wandler (14) mit einem Eingang eines Computers (17) verbunden sowie im unverlierbaren Speicher (11) ein bestimmter vorgegebener Bitwert (UPI) gespeichert ist und dass im Betrieb zeitlich abwechselnd ein internes Taktsignal (CLK) oder ein vom Computer (17) gesandtes Schnittstellen-Taksignal (SCK) auf einen Takteingang des Serie/Parallel-Wandlers (14) geführt ist zwecks einem jeweils zeitseriellen Hineinschieben eines digitalen Leistungswertes aus dem Analog/Digital-Wandler (2) in den Serie/Parallel-Wandler (14) beziehungsweise des dort gespeicherten digitalen Leistungswertes aus dem Serie/Parallel-Wandler (14) in den Computer (17).

26. Anordnung nach Anspruch 25, **dadurch gekennzeichnet, dass** nach dem Hineinschieben in den Serie/Parallel-Wandler (14) jeweils ein zum Computer (17) gesandtes Betriebsbereit-Signal (RDY) vorhanden ist, welches zeitlich gefolgt ist von zwei seitens des Computers (17) zeitweise über getrennte Leiter (20, 19) gesandten Signalen (SCK, ENI), wobei ein erstes der beiden Signale (SCK, ENI) ein Schnittstellen-Taktsignal (SCK) und ein zweites ein Schnittstellen-Freigabesignal (ENI) ist, und dass ein Empfang des letzteren eine Beendigung des Betriebsbereit-Signal (RDY) sowie ein Umschalten des Takteingangs des Serie/Parallel-Wandlers (14) vom internen Taktsignal (CLK) auf das Schnittstellen-Taktsignal (SCK) zur Folge hat.

## Claims

1. Arrangement for measuring electrical energy with at least a measuring equipment and with for each measuring equipment
- an arrangement (1) for the determination of analog power values (p[t]) and
- an analog to digital converter (2) connected downstream to an arrangement (1) for the determination of analog power values (p[t]),
- in which case an arrangement (10) for the digital quantization is connected downstream to the analog to digital converter (2),
**characterised by** the fact that the analog to digital converter (2) contains respectively a sigma-delta modulator (8) as well as a digital filter (9) connected downstream to the latter and that a pole changer (3) is available in the arrangement (1) for the determination of analog power values (p[t]) and that a pole changer is available in the sigma-delta modulator (8), whose commutating frequency (2⁵ Hz) is an integral multiple of a scanning rate (4 Hz) of the digital filter (9), in which case the pole changer in the arrangement (1) switches over the analog power values (p[t]) a first time periodically and the pole changer of the sigma-delta modulator (8) switches over the analog power values (p[t]) a second time periodically and furthermore it switches over an offset voltage one-time periodically, this offset voltage being available on the side of the arrangement (1) output, so that a subsequent production of a mean value of the half-waves in the digital filter (9) eliminates this offset voltage of the arrangement (1) and merely the analog power values (p[t]) are taken into account.

2. Arrangement according to claim 1, **characterised by** the fact that the quantization is controllable by means of a calibration value (N_{K}) memorised in a non-volatile memory (11).

3. Arrangement according to claim 2, **characterised by** the fact that the calibration value (N_{K}) is a variable portion of a calibration factor (N'_{K}).

4. Arrangement according to claim 2 or 3, **characterised by** the fact that the non-volatile memory (11) is a field programmable ROM or an electrical programmable read-only memory (FPROM, respectively EEPROM), whose bus output unit (11a) is connected with a bus input unit (10a) of the arrangement (10) for the digital quantization.

5. Arrangement according to one of the claims 2 to 4, **characterised by** the fact that the arrangement (10) for the digital quantization is a computer (12) which is equipped with a software carrying out the digital quantization and the non-volatile memory (11) is part of the computer memory.

6. Arrangement according to claim 5, **characterised by** the fact that only one computer (12), common to all measuring units, is available as arrangement (10) for the digital quantization.

7. Arrangement according to claim 5 or 6, **characterised by** the fact that an output unit of the analog to digital converter (2) is connected with the computer (12) respectively through a serial interface (13).

8. Arrangement according to claim 5 or 6, **characterised by** the fact that an output unit of the analog to digital converter (2) is connected with the computer (12, 17) respectively through a series-parallel converter (14) and a communication interface (16) connected with the serial output unit (14a) of this series-parallel converter (14).

9. Arrangement according to one of the claims 2 to 4, **characterised by** the fact that the arrangement (10) for the digital quantization is a digital hardware quantifier.

10. Arrangement according to claim 9, **characterised by** the fact that a serial output unit of the analog to digital converter (2) is guided to a serial input unit (IN) of a series-parallel converter (14), whose parallel output unit is connected with an bus input unit (10b) of the digital hardware quantifier.

11. Arrangement according to the claim 9 or 10, **characterised by** the fact that in the digital hardware quantifier
- a bus entry unit of a first intermediate memory (24) constitute the bus input unit (10b) of the digital hardware quantifier
- a multiple bit commutator (25) controlled by a first clock signal (CL2) is available for a periodically alternating connection of a first bus input (B) of an algebraic adder (26) with a bus output unit (24a, respectively 23a) of the first intermediate memory (24), respectively of a bit expander circuit (23), in which case the calibration value (N_{K}), memorized in the non-volatile memory (11), is applied to a bus input unit (23b) of this bit expander circuit (23),
- a bus input unit (S) of the algebraic adder (26) is connected with a bus input unit of a second intermediate memory (27), whose bus output unit is guided to a second bus input unit (A) of the algebraic adder (26),
- that a release gate (30) is available for charging the output value of the algebraic adder (26) in the second intermediate memory (27) by means of a second clock signal (CL4), all this if the first bus input (B) of the algebraic adder (26) is connected with the bus output unit (24a) of the first intermediate memory (24),
- that during the time in which the first bus input unit (B) of the algebraic adder (26) is connected with the bus output unit (23a) of the bit expander circuit (23), in case of a negative value (POUT), memorised in the first intermediate memory (24), the algebraic adder (26) is a summing element and in case of a positive value (POUT), memorised in the first intermediate memory (24), the algebraic adder (26) is a subtractive element, whose initial value, in the latter case, is equal to the difference (X-N'_{K}) between a value (X) memorised precisely in the second intermediate memory (27) and the value of a calibration factor (N'_{K}) applied at the bus output unit (23a) of the bit expander circuit (23),
- that these output units of the bus output units (24a, S) of the first intermediate memory (24) and of the algebraic adder (26), to which respectively the most higher bit (MSB1, respectively MSB2) is applied, are connected each with a input unit of a down-streamed pulse generator (41) for the purpose of the relative production of a pulse at the output unit of the pulse generator (41) if during the time at which the first bus input unit (B) of the algebraic adder (26) is connected with the bus output unit (23a) of the bit expander circuit (23), both most higher bits (MSB1, respectively MSB2) are identical, and
- that the output unit of the pulse generator (41) is connected with a charging input unit (27a) of the second intermediate memory (27).

12. Arrangement according to one of the claims 1 to 11, **characterised by** the fact that the digital filter (9) contains at least a filtering level, whose transfer function is at least of second order (Sinc^{K} avec K ≥2).

13. Arrangement according to claim 12, **characterised by** the fact that the digital filter (9) contains a series circuit of a first Sinc²-Filter (42) and of a second down-streamed Sinc²-Filter (43).

14. Arrangement according to claim 13, **characterised by** the fact that the first and the second Sinc²-Filter (42, 43) respectively contain a first digital integrator (44, respectively 57) and a second down-streamed digital integrator (45, respectively 59), the latter of which has a resetting and that after the second digital integrator (45, respectively 59) a decimation is available, which is respectively connected downstream to the digital differentiation element (54).

15. Arrangement according to claim 14, **characterised by** the fact that the first Sinc²-Filter (42) has 12 bits as well as a decimation factor value of 32 and that the second Sinc²-Filter (43) has 32 bits as well as a decimation factor value 1024.

16. Arrangement according to one of the claims 2 to 15, **characterised by** the fact that the non-volatile memory (11) is programmable by a computer (17) through a serial communication interface (16).

17. Arrangement according to claim 16, **characterised by** the fact that the serial communication interface (16) is receiver and memory for bit values of a code word (N_{K}, respectively pseudo - calibration value) as well as additional bits (DPW, UPI, TUPI, TPRG, TRFP, TPRE, BTF); these bit values being emitted on the part of the computer (17) and this code word (N_{K}, respectively pseudo - calibration value) related to the calibration value (N_{K}).

18. Arrangement according to claim 16 or 17, **characterised by** the fact that the bits belonging to the bit values emitted from the computer (17) have the shape of a time serial signal (MOSI) transferred through a conductor (18) of an interface bit connection of communication (16b) and that in the interface bit connection of communication (16b) at least three other conductors (19, 20, 21) are available through which an interface clock signal (SKC), respectively an interface release signal (ENI), respectively an programming pulse (PRG) is transferred from the computer (17) to the arrangement, whereas the programming pulse (PRG) serves thereto with the aid of one of the additional received bits (TRPG) to store the word code (N_{K}, respectively pseudo - calibration value) related to the calibration value (N_{K}) in the non-volatile memory (11).

19. Arrangement according to one of the claims 16 to 18, **characterised by** the fact that the serial communication interface (16) thus contains a shift register (62) for a time serial storing of the bit values (N_{K}, pseudo - calibration values, DPW, UPI, TUPI, TPRG, TRFP, TPRE, BTF) emitted by the computer (17) as well as a programming release arrangement (64); the shift register (62) and the programming release arrangement (64) are there for the transmission of at least a part of the bit values (N_{K}, pseudo - calibration values, DPW, UPI, BTF), memorised in the shift register (62), to the non-volatile memory (11) for the purpose of a storage in that place and that an auxiliary memory (72) is available for the storage of another part of the bit values (TUPI, TPRG, TRFP, TPRE) memorised in the shift register (62).

20. Arrangement according to claim 16, **characterised by** the fact that the output unit of the non-volatile memory (11) is connected, through a bus connection, with a parallel input unit of memory cells of the shift register (62), these memory cells belonging to the calibration value (N_{K}) with the purpose of re-memorisation of the content (N_{K}) of the non-volatile memory (11) in the shift register (62) whose content is then transferable for the purpose of reading in that place the content (N_{K}) of the non-volatile memory.

21. Arrangement according to claim 19 or 20, **characterised by** the fact that the programming release arrangement (64) contains a release gate (64a) for a memory cell belonging to the non-volatile memory (11) for the purpose of a storage in that place of an inhibit bits (BTF) temporarily memorised in the shift register (62) and transferred from the computer (17) through the communication interface (16) and that an output unit of the related memory cell of the non-volatile memory (11) is connected with a input unit of a barrier gate (208) for the purpose of blocking other release gate (64a) of the programming release arrangement (64).

22. Arrangement according to one of the claims 19 to 21, **characterised by** the fact that from parallel output units of the shift register (62), these parallel output units belonging to the calibration value (N_{K}), are connected with an input unit of an other auxiliary storage (203) and that a multiple bit commutator (204) is available for the purpose of switching the bus input unit (10a) of the arrangement (10) for the digital quantization from the bus input unit (11a) of the non-volatile memory (11) on an bus input unit of a further auxiliary memory (203).

23. Arrangement according to one of the claims 16 to 22, **characterised by** the fact that an output unit of the analog to digital converter (2) is connected, thanks to a series-parallel converter (14), with an input unit of the computer (17) and in operation, after the storage of a given preset bit value (TUPI) emitted by the computer (17), temporally alternating an internal clock signal (CLK) or an interface clock signal (SCK) transmitted from a computer (17) is guided on a clock input unit of the series-parallel converter (14) for the purpose of a respectively time serial pushing of a digital power value out of the analog to digital converter (2) in the series-parallel converter (14), respectively the digital power value memorised over there out of the series-parallel converter (14) in the computer (17).

24. Arrangement according to the claim 23, **characterized by** the fact that after pushing in the series-parallel converter (14), respectively a ready for work signal (RDY) transmitted to the computer (17) is available, which is chronologically followed by an interface clock signal (SCK) transmitted on the part of the computer (17) from time to time through a separate conductor (20) and that a reception of the latter causes an ending of the ready for work signal (RDY) and a commutation of the clock input unit of the series-parallel converter (14) from an internal clock signal (CLK) to the interface clock signal (SCK).

25. Arrangement according to one of the claims 2 to 24, **characterised by** the fact that an output unit of the analog to digital converter (2) is connected, thanks to a series-parallel converter (14), with an input unit of the computer (17) as well as a given preset bit value (UPI) is memorised in the non-volatile memory (11) and in operation temporally alternating an internal clock signal (CLK) or an interface clock signal (SCK) transmitted by a computer (17) is guided on a clock input unit of the series-parallel converter (14) for the purpose of respectively a time serial pushing of a digital power value out of the analog to digital converter (2) in the series-parallel converter (14), respectively of the digital power value memorised over there out of the series-parallel converter (14) into the computer (17).

26. Arrangement according to claim 25, **characterised by** the fact that after the pushing in the series-parallel converter (14), respectively an operative signal (RDY) transmitted to the computer (17) is available, which is chronologically followed by two signals (SCK, ENI) transmitted on the part of the computer (17) from time to time through separate conductors (20, 19), whereas a first of the two signals (SCK, ENI) is a interface clock signal (SCK) and a second is an interface release signal (ENI) and that a reception of the latter causes an ending of the operative signal (RDY) and a commutation of the clock input unit of the series-parallel converter (14) from an internal clock signal (CLK) to the interface clock signal (SCK).

## Revendications

1. Disposition pour mesurer de l'énergie électrique avec au moins un système de mesure et avec pour chaque système de mesure
- une disposition (1) pour la détermination de valeurs de puissance analogiques (p[t]) et
- un convertisseur analogique numérique (2) branché en aval de la disposition (1) pour la détermination de valeurs de puissance analogiques (p[t]),
- auquel cas une disposition (10) pour la quantification numérique est branché en aval du convertisseur analogique numérique (2),
**caractérisé par le fait que** le convertisseur analogique numérique (2) contient respectivement un modulateur sigma-delta (8) ainsi qu'un filtre numérique (9) branché en aval de ce dernier et qu'un commutateur de polarité (3) est disponible dans la disposition (1) pour la détermination de valeurs de puissance analogiques (p[t]) et qu'un commutateur de polarité est disponible dans le modulateur sigma-delta (8), dont leur fréquence de commutation (2⁵ Hz) est un multiple entier d'une fréquence de balayage (4 Hz) du filtre numérique (9), auquel cas le commutateur de polarité dans la disposition (1) commute une première fois de façon périodique les valeurs de puissance analogiques (p[t]) et le commutateur de polarité du modulateur sigma-delta (8) commute une deuxième fois de façon périodique les valeurs de puissance analogiques (p[t]) et à cette fin il commute une seule fois de façon périodique la tension offset présente du côté de la sortie de la disposition (1), de sorte qu'une formation de valeur moyenne consécutive des demi-ondes dans le filtre digital (9) élimine cette tension offset de l'arrangement (1) et seulement les valeurs de puissance analogiques (p[t]) sont prises en considération.

2. Disposition selon la revendication 1, **caractérisée par le fait que** la quantification est réglable à l'aide d'une valeur de calibrage (N_{K}) sauvée dans une mémoire non volatile (11).

3. Disposition selon la revendication 2, **caractérisée par le fait que** la valeur de calibrage (N_{K}) est une partie variable d'une constante de calibrage (N'_{K}).

4. Disposition selon la revendication 2 ou 3, **caractérisée par le fait que** la mémoire non volatile (11) est une mémoire à lecture seule à contenu programmable par l'utilisateur ou une mémoire à lecture seule électriquement programmable (FPROM, respectivement EEPROM) dont la sortie bus (11a) est relié à une entrée bus (10a) de la disposition (10) pour la quantification numérique.

5. Disposition selon une des revendication de 2 à 4, **caractérisée par le fait que** la disposition (10) pour la quantification numérique est un ordinateur (12) qui est équipé d'un logiciel effectuant la quantification numérique et la mémoire non volatile (11) est une partie de la mémoire de l'ordinateur.

6. Disposition selon la revendication 5, **caractérisée par le fait qu'**un seul ordinateur (12) commun à tous les systèmes de mesure est disponible comme disposition (10) pour la quantification numérique.

7. Disposition selon la revendication 5 ou 6, **caractérisée par le fait qu'**une sortie du convertisseur analogique numérique (2) est reliée à l'ordinateur (12) respectivement à travers une interface (13) sérielle.

8. Disposition selon la revendication 5 ou 6, **caractérisée par le fait qu'**une sortie du convertisseur analogique numérique (2) est reliée avec l'ordinateur (12, 17) respectivement à travers un convertisseur série-parallèle (14) et une interface de communication (16) qui elle est raccordée à la sortie sérielle (14a) de ce convertisseur série-parallèle (14).

9. Disposition selon une des revendications de 2 à 4, **caractérisée par le fait que** la disposition (10) pour la quantification numérique est un dispositif de quantification numérique du matériel.

10. Disposition selon la revendication 9, **caractérisée par le fait qu'**une sortie sérielle du convertisseur analogique numérique (2) est conduite à une entrée sérielle (IN) d'un convertisseur série-parallèle (14) dont la sortie parallèle est reliée à une entrée bus (10b) du dispositif de quantification numérique du matériel.

11. Disposition selon la revendication 9 ou 10, **caractérisée par le fait que** dans le dispositif de quantification numérique du matériel
■ une entrée bus d'une première mémoire temporaire ou de travail (24) forme l'entrée bus (10b) du dispositif de quantification numérique du matériel,
■ un commutateur à plusieurs bit (25), commandé par un premier signal de synchronisation (CL2), est disponible pour une connexion alternative périodique d'une première entrée bus (B) d'un additionneur algébrique (26) avec une sortie bus (24a, respectivement 23a) de la première mémoire temporaire ou de travail (24), respectivement d'un circuit à extension de bit (23), auquel cas la valeur de calibrage (N_{K}) sied à une entrée bus (23b) de ce circuit à extension de bit (23); cette valeur de calibrage (N_{K}) étant mémorisée dans la mémoire non-volatile,
■ une sortie bus (S) de l'additionneur algébrique (26) est relié avec une entrée bus d'une deuxième mémoire temporaire ou de travail (27) dont la sortie bus est conduite sur une deuxième entrée bus (A) de l'additionneur algébrique (26),
■ qu'une porte d'autorisation (30) est disponible pour le chargement de la valeur de sortie de l'additionneur algébrique (26) dans la deuxième mémoire temporaire ou de travail (27) à l'aide d'un deuxième signal de synchronisation (CL4), tout ceci si la première entrée bus (B) de l'additionneur algébrique (26) est relié avec la sortie bus (24a) de la première mémoire temporaire ou de travail (24),
■ que dans le temps pendant lequel la première entrée bus (B) de l'additionneur algébrique (26) est reliée avec la sortie bus (23a) du circuit à extension de bit (23), lors d'une valeur négative (POUT) de l'additionneur algébrique (26) mémorisée dans la première mémoire temporaire ou de travail (24), l'additionneur algébrique (26) est un élément d'addition et lors d'une valeur positive (POUT) mémorisée dans la première mémoire temporaire ou de travail (24), l'additionneur algébrique (26) est un élément de soustraction dont la valeur de sortie, dans le tout dernier cas, est égale à la différence (X-N'_{K}) entre une valeur (X) mémorisée précisément dans la deuxième mémoire temporaire ou de travail (27) et la valeur d'une constante de calibrage (N'_{K}) étant à la sortie bus (23a) du circuit à extension de bit (23),
■ que ces sorties des sorties bus (24a, S) de la première mémoire temporaire ou de travail (24) et de l'additionneur algébrique (26), auxquelles respectivement le bit de plus haute valeur (MSB 1, respectivement MSB2) sied, sont reliées chacune avec une entrée d'un générateur d'impulsion (41) branché en aval dans le but d'une production respective d'une impulsion à la sortie du générateur d'impulsion (41), si lors du temps pendant lequel la première entrée bus (B) de l'additionneur algébrique (26) est reliée à la sortie bus (23a) du circuit à extension de bit (23), les deux bits de plus haute valeur (MSBI, MSB2) sont identiques, et
■ que la sortie du générateur d'impulsion (41) est reliée à une entrée de chargement (27a) de la deuxième mémoire temporaire ou de travail (27).

12. Disposition selon une des revendications de 1 à 11, **caractérisée par le fait que** le filtre numérique (9) contient au moins un niveau de filtration dont la fonction de transfert est au moins du deuxième ordre (Sinc^{K} avec K≥2).

13. Disposition selon la revendication 12, **caractérisée par le fait que** le filtre numérique (9) contient un circuit en série d'un premier Filtre-Sinc² (42) et d'un deuxième Filtre-Sinc² (43) branché en aval.

14. Disposition selon la revendication 13, **caractérisée par le fait que** le premier et le deuxième Filtre-Sinc² (42, 43) contiennent respectivement un premier circuit d'intégration numérique (44, respectivement 57) et un deuxième circuit d'intégration numérique branché en aval (45, respectivement 59) dont le dernier possède une remise à l'état initiale et qu'après le deuxième circuit d'intégration numérique (45, respectivement 59) une décimation est disponible, à laquelle respectivement un élément de différentiation numérique (54) est branché en aval.

15. Disposition selon la revendication 14, **caractérisée par le fait que** le premier Filtre-Sinc² (42) possède 12 bits ainsi qu'une valeur de facteur de décimation 32 et que le deuxième Filtre-Sinc² (43) possède 32 bits ainsi qu'une valeur de facteur de décimation 1024.

16. Disposition selon une des revendications de 2 à 15, **caractérisée par le fait que** la mémoire non volatile (11) est programmable par un ordinateur (17) à travers une interface de communication sérielle (16).

17. Disposition selon la revendication 16, **caractérisée par le fait que** l'interface de communication sérielle (16) est récepteur et mémoire pour des valeurs de bit d'un mot code (N_{K}, respectivement pseudo - valeur de calibrage) ainsi que de bits supplémentaires (DPW, UPI, TUPI, TPRG, TRFP, TPRE, BTF); ces valeurs de bit étant émises de la part de l'ordinateur (17) et ce mot code (N_{K}, respectivement pseudo - valeur de calibrage) étant en relation avec la valeur de calibrage (N_{K}).

18. Disposition selon la revendication 16 ou 17, **caractérisée par le fait que** les bits appartenants aux valeurs de bit émises par l'ordinateur (17), possèdent la configuration d'un signal sériel du point de vue du temps (MOSI) transféré à travers un conducteur (18) d'une connexion bus d'interface de communication (16b) et que dans la connexion bus d'interface de communication (16b) au moins trois autres conducteurs (19, 20, 21) sont disponibles à travers lesquels un signal de synchronisation d'interface (SKC), respectivement un signal d'autorisation (ENI), respectivement une impulsion de programmation (PRG) est transférée de l'ordinateur (17) à la disposition, auquel cas l'impulsion de programmation (PRG) sert en plus, à l'aide d'un des bits supplémentaires reçus (TRPG), à mémoriser le mot code (N_{K}, respectivement pseudo - valeur de calibrage), étant en relation avec la valeur de calibrage (N_{K}), dans la mémoire non volatile (11).

19. Disposition selon une des revendications de 16 à 18, **caractérisée par le fait que** l'interface de communication sérielle (16) contient un registre à décalage (62) pour la mémorisation sérielle du point de vue du temps des valeurs de bit (N_{K}, pseudo - valeurs de calibrage), DPW, UPI, TUPI, TPRG, TRFP, TPRE, BTF) émises par l'ordinateur (17) ainsi qu'une disposition d'autorisation de programmation (64); le registre à décalage (62) et la disposition d'autorisation de programmation (64) sont là pour la transmission d'au moins une partie des valeurs de bit (N_{K}, pseudo - valeurs de calibrage, DPW, UPI, BTF), mémorisées dans le registre à décalage (62), à la mémoire non volatile (11) dans le but d'une mémorisation en ce lieu et qu'une mémoire auxiliaire (72) est disponible pour mémoriser une autre partie des valeurs de bit (TUPI, TPRG, TRFP, TPRE) mémorisées dans le registre à décalage (62).

20. Disposition selon la revendication 19, **caractérisée par le fait que** la sortie de la mémoire non volatile (11) est reliée, à travers une connexion bus, avec entrée parallèle de cellules de mémoire du registre à décalage (62), ces cellules de mémoire appartenant à la valeur de calibrage (N_{K}) dans le but d'une re-mémorisation du contenu (N_{K}) de la mémoire non volatile (11) dans le registre à décalage (62) dont le contenu est ensuite transférable dans le but d'une lecture en ce lieu du contenu (N_{K}) de la mémoire non volatile (11).

21. Disposition selon la revendication 19 ou 20, **caractérisée par le fait que** la disposition d'autorisation de programmation (64) contient une porte d'autorisation (64a) pour une cellule de mémoire apparentée de la mémoire non volatile (11) dans le but d'une mémorisation en ce lieu d'un bit de blocage (BTF) transféré de l'ordinateur (17) à travers l'interface de communication (16) et mémorisé temporairement dans le registre à décalage (62) et que une sortie de la cellule de mémoire en question de la mémoire non volatile (11) est liée avec une entrée de la grille d'arrêt (208) dans le but d'un blocage d'autres portes d'autorisation (64a) de la disposition d'autorisation de programmation (64).

22. Disposition selon une des revendications de 19 à 21, **caractérisée par le fait que** par des sorties parallèles, appartenantes à la valeur de calibrage (N_{K}), du registre à décalage (62) sont reliées avec une entrée bus d'une autre mémoire auxiliaire (203) et qu'un commutateur à plusieurs bits (204) est disponible dans le but d'une commutation de l'entrée bus (10a) de la disposition (10) pour la quantification numérique à partir de l'entrée bus (11a) de la mémoire non volatile (11) sur une entrée bus d'une autre mémoire auxiliaire (203).

23. Disposition selon une des revendications de 16 à 22, **caractérisée par le fait qu'**une sortie du convertisseur analogique numérique (2) est reliée grâce à un convertisseur série-parallèle (14) avec une entrée de l'ordinateur (17) et en fonctionnement, après la mémorisation d'une certaine valeur de bit prédéfinie (TUPI) émise par l'ordinateur (17), temporellement à tour de rôle un signal de synchronisation interne (CLK) ou un signal de synchronisation d'interface (SCK) envoyée par l'ordinateur (17) est guidé sur une entrée d'horloge du convertisseur série-parallèle (14) dans le but de pousser respectivement de façon sérielle du point de vue du temps une valeur de puissance numérique hors du convertisseur analogique numérique (2) dans le convertisseur série-parallèle (14), respectivement la valeur de puissance numérique mémorisée là-bas hors du convertisseur série-parallèle (14) dans l'ordinateur (17).

24. Disposition selon la revendication 23, **caractérisée par le fait qu'**après le fait de pousser dans le convertisseur série-parallèle (14), respectivement un signal en état d'exploitation (RDY) envoyé à l'ordinateur (17) est disponible, lequel est temporellement suivi par un signal de synchronisation d'interface (SCK) envoyée de la part de l'ordinateur (17) de temps en temps à travers un conducteur séparé (20) et qu'une réception de ce dernier a comme conséquence un achèvement du signal en état d'exploitation (RDY) et une commutation de l'entrée de synchronisation du convertisseur série-parallèle (14) d'un signal de synchronisation interne (CLK) au signal de synchronisation d'interface (SCK).

25. Disposition selon une des revendications de 2 à 24, **caractérisée par le fait qu'**une sortie du convertisseur analogique numérique (2) est reliée grâce à un convertisseur série-parallèle (14) à une entrée d'un ordinateur (17) ainsi qu'une certaine valeur de bit prédéfinie est mémorisée dans la mémoire non volatile (11) et qu'en fonctionnement, temporellement à tour de rôle, un signal de synchronisation interne (CLK) ou un signal de synchronisation d'interface (SCK) envoyée par l'ordinateur (17) est conduit sur une entrée de synchronisation du convertisseur série-parallèle (14) dans le but de respectivement pousser de façon sérielle du point de vue du temps une valeur de puissance numérique hors du convertisseur analogique numérique (2) dans le convertisseur série-parallèle (14), respectivement la valeur de puissance numérique mémorisée là-bas hors du convertisseur série-parallèle (14) dans l'ordinateur (17).

26. Disposition selon la revendication 25, **caractérisée par le fait qu'**après le fait de pousser dans un convertisseur série-parallèle (14), respectivement un signal en état d'exploitation (RDY) envoyé à l'ordinateur (17) est disponible, lequel est temporellement suivi par deux signaux (SCK, ENI) envoyée de la part de l'ordinateur (17) de temps en temps à travers des conducteurs séparés (20, 19), auquel cas un premier des deux signaux (SCK, ENI) est un signal de synchronisation d'interface (SCK) et un deuxième est un signal d'autorisation d'interface (ENI) et qu'une réception de ce dernier a comme conséquence un achèvement du signal en état d'exploitation (RDY) ainsi qu'une commutation de l'entrée de synchronisation du convertisseur série-parallèle (14) d'un signal de synchronisation interne (CLK) au signal de synchronisation d'interface (SCK).
